# EUROPEAN PATENT SPECIFICATION

(11) **EP 1 207 625 B1**
(45) Date of publication and mention of the grant of the patent: **11.05.2005**
(21) Application number: 01305811.0
(22) Date of filing: 05.07.2001
(51) Int. Cl.: H03M 13/29, H04B 1/707

(54) **Method of decoding turbo-encoded data and receiver for decoding turbo-encoded data**
Verfahren zur Dekodierung von turbokodierten Daten und Empfänger zur Dekodierung von turbokodierte Daten
Méthode de décodage de données turbo-encodées et récepteur pour le décodage de données turbo-encodées

(43) Date of publication of application: 22.05.2002
(73) Proprietor: NEC CORPORATION, Tokyo (JP)
(72) Inventor: Maru, Tsuguo, Minato-ku, Tokyo (JP)
(74) Representative: Abnett, Richard Charles

(56) References cited:
- EP-A- 1 017 178
- EP-A- 1 054 523
- WO-A-00/74247
- GB-A- 2 354 918
- ROBERTSON P. ET AL: 'A COMPARISON OF OPTIMAL AND SUB-OPTIMAL MAP DECODING ALGORITHMS OPERATING IN THE LOG DOMAIN' PROCEEDINGS OF THE INTERNATIONAL CONFERENCE ON COMMUNICATIONS (ICC) vol. 2, 18 June 1995, pages 1009 - 1013

## Description

### BACKGROUND OF THE INVENTION

### FIELD OF THE INVENTION

The invention relates to a method of decoding turbo-encoded data and a receiver for decoding turbo-encoded data both of which are suitable for a mobile communication system which operates in CDMA (Code Division Multiple Access).

### DESCRIPTION OF THE RELATED ART

There has been suggested a method of encoding data, called a turbo code, in which an error rate close to the Shannon limit can be accomplished in encoding data, by C. Berrou et al.. This method is explained in detail, for instance, in Proceeding of International Conference of communication, pp. 1064-1070, May 1993.

The method of turbo-encoding data is characterized by the step of dividing a code having a high complexity in decoding data, into a plurality of components each having a low complexity in decoding data; to thereby successively enhance accuracy in decoding the data by virtue of interaction among those components. Division of a code having a high complexity in decoding data, into a plurality of components each having a low complexity in decoding data is carried out by a maximum posterior probability (MAP) decoder which carries out soft-input and soft-output decoding.

The BCJR (Bahl, Cocke, Jelinek and Raviv) algorithm is known as an algorithm for consistently accomplishing MAP decoding, but is accompanied by the problem of requiring too much calculation. In order to reduce calculation, the Max-Log MAP algorithm and SOVA (Soft-Output Viterbi Algorithm) have been suggested, both of which carry out approximate calculations. Herein, Max-Log MAP algorithm which carries out approximation of calculation in BCJR algorithm in the log domain and the SOVA algorithm is a process to have soft-input and soft-output on the basis of the Viterbi algorithm.

In CDMA mobile communication systems control of the power of a data transmitter is carried out in order to keep the power at minimum and increase the system capacity as much as possible. In addition, since the CDMA system can have a high gain in encoding data, by virtue of statistics multiple, enhancement of the ability to decode data in a turbo decoder would bring the advantage that the number of subscribers covered by the CDMA system can be increased.

However, the above-mentioned Max-Log MAP algorithm and SOVA algorithm are accompanied by the problem of degradation in the characteristics thereof, though they can reduce calculation.

In order to solve this problem, there is known a method of carrying out a calculation equivalent to the BCJR algorithm, in the log domain with reference to a table in which a correction term fc (|δ₁ - δ₂|) is defined as a function of (|δ₁ - δ₂|) in Max-Log MAP, based on the Jacobian Logarithm:$\text{ln(} {\text{e}}^{\text{δ1}} \text{+} {\text{e}}^{\text{δ2}} {\text{)=max(δ}}_{\text{1}} {\text{,δ}}_{\text{2}} \text{)+ln(1+} {\text{e}}^{\text{-|δ2-δ1|}} {\text{)=max(δ}}_{\text{1}} \text{,δ2)+} \text{fc} \text{(} \left|{\text{δ}}_{\text{2}} {\text{-δ}}_{\text{1}}\right| \text{)}$

However, if the above-mentioned equation (1) were arranged into a table, it would be unavoidable for the table to become large in size.

For instance, hereinbelow a process of updating alpha metric is explained as an example. The alpha metric and above-mentioned beta metric and gamma metric correspond to α, β and γ, respectively, and are described in detail, for instance, in IEEE Transaction on Information Theory, pp. 284-287, March 1974.

First, it is assumed that two alpha metrics selected on a trellis at a particular time are expressed as α₁ and α₂, and the values of the alpha metrics in the log domain are expressed as α_{log1} and α_{log2}. That is, α₁ and α₂ are expressed as follows:${\text{α}}_{\text{1}} {\text{= exp [α}}_{\text{log1}} \text{]}$${\text{α}}_{\text{2}} {\text{= exp [α}}_{\text{log2}} \text{]}$

In addition, it is assumed that the gamma metrics associated with the alpha metrics on a trellis are expressed as γ₁ and γ₂, and values of the gamma metrics in the log domain, are expressed as γ_{log1} and γ_{log2}. Unless explicitly expressed, the product of α₁ and γ₁ is equal to or greater than the product of α₂ and γ₂(α₁γ₁ ≧ α₂γ₂).

Herein, it is assumed that an alpha metric having been updated is expressed as α₃, and the value of the alpha metric α₃ in the log domain is expressed as follows:

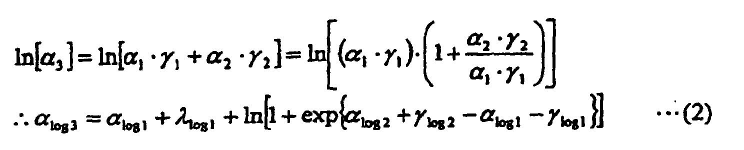

Accordingly, a term corresponding to the correction term fc (|δ₁ - δ₂|) in the above-mentioned equation (1) is expressed as follows:

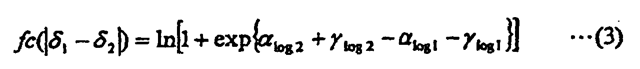

Herein, the gamma metric is expressed as follows.

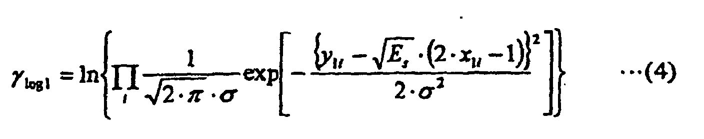

The equation (4) is substituted for the equation (3) to thereby cancel common terms. As a result, the following equation (5) is obtained:

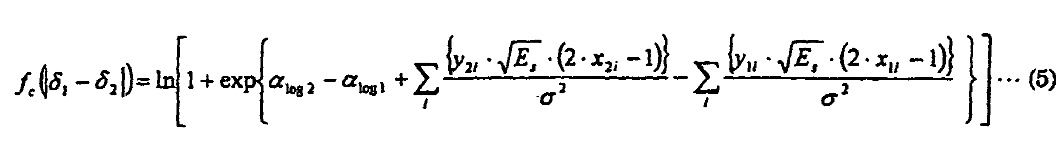

In the equation (5), the correction term fc (|δ₁ - δ₂|) contains noise variance σ² and a signal component Es. Hence, it is necessary to update the values in the Jacobian table by multi-pass phasing each time noises and/or signal levels are varied.

However, since the noise variance σ² and the signal component Es are also used in a process of updating the beta metric and an equation for computing likelihood, it would be necessary for the memory used to have a great capacity.

In addition, it would be necessary for the circuit to include an additional memory to store the noise variance σ² and the signal components Es associated with the positions of bits in each of the data series and the parity series, resulting in an increase in the size of the circuit. This would make it impossible to fabricate the circuit in a small size, with a low consumption of power, and with small fabrication costs. Furthermore, steps of measuring the noise variance σ² and the signal component Es have to be additionally carried out.

Since referring to a table comprised of a memory having a great capacity is carried out at a low rate, such a low rate would be a bottle neck for the processing rates of an ACS circuit and a comparison/selection circuit both of which cannot have a pipeline structure.

Japanese Unexamined Patent Publication No. 6-132936 has suggested a digital transmission system in which digital data to be transmitted is encoded by means of an encoding circuit at the transmitter, the thus-encoded data is transmitted in the form of a modulated signal into a transmission path, and the modulated signal is decoded by means of a decoding circuit at a recipient. The encoding circuit is comprised of a first unit which groups channels in accordance with the importance of the digital data to be transmitted, a second unit which weights the digital data in accordance with a predetermined weighting method, and a modulator which multiplexes the weighted digital data to thereby produce a modulated signal and transmits the thus-produced modulated signal into the transmission path. The decoding circuit is comprised of a demodulator which receives the modulated signal and demodulates the received modulated signal, a third unit which checks the receipt condition in each of the channels in accordance with the thus demodulated digital data, and a data selector which selects the digital data in an order of highly weighted channels in accordance with the receipt condition in each of the channels.

Japanese Unexamined Patent Publication No. 9-261203, based on U.S. Patent Application Serial No. 08/617,462 filed on March 18, 1996, has suggested a method of determining a weighting coefficient in a CDMA radio-signal receiver, including the steps of receiving a first expression expressed in desired RF signals, transmitting a plurality of first data signals in accordance with the first expression, transmitting a plurality of first pilot signals in accordance with the first expression, measuring first total power of received signals, and determining a plurality of first weighting coefficients in accordance with the data signals, the pilot signals and the first total power.

Japanese Patent No. 2877248 (Japanese Unexamined Patent Publication No. 8-37515) has suggested a method of controlling the power of a first transmission signal transmitted from a first station, in accordance with a control signal included in a second transmission signal transmitted from a second station and received at the first station. The method includes the steps of decoding the second transmission signal at the first station by means of a first Viterbi decoder including a path memory having a first predetermined length, decoding the second transmission signal at the first station by means of a second Viterbi decoder including a path memory having a second predetermined length shorter than the first predetermined length, extracting the control signal from output signals transmitted from the second Viterbi decoder, at the first station, controlling the power of the first transmission signal in accordance with the control signal having been extracted from the output signals transmitted from the second Viterbi decoder, and extracting data other than the control signal, from output signals transmitted from the first Viterbi decoder, at the first station.

Japanese Unexamined Patent Publication No. 6-261021, based on U.S. Patent Application Serial No. 991841 filed on December 16, 1992, has suggested a device used in a CDMA system in which encoded user signals are transmitted to each of a plurality of users, the user signals are produced by processing user signals with an associated sequence of encoding coefficients, and a received signal includes a combination of the encoded user signals. The device is comprised of means for receiving samples of the received signals received at a predetermined interval, and means for predicting users' symbols in response to the samples through the use of the extracted sequence of encoding coefficients. The sequence of encoding coefficients is defined as an interactive function of a sequence of encoding coefficients, associated with the users, and a sequence of encoding coefficients, associated with other users.

Japanese Unexamined Patent Publication No. 2000-4196, based on U.S. Patent Application Serial No. 09/038724, has suggested a multiple access system of communication across a wireless interface, including a turbo encoder for turbo coding signal representations of packets of information, a transmitter for transmitting a first signal representation of a first packet of information and a second signal including a re-transmission of part of the first signal and a new signal representation of a second packet of information, a receiver for receiving the signal representations, and a means for processing the signal representations by combining the transmitted signals with the re-transmitted signals to obtain an output signal representation of the packet of information the transmitted and re-transmitted signals being combined using rake processing.

WO 00/74247 discloses a turbo decoding architecture for WCDMA receivers, in which the turbo decoder makes use of signal-to-noise ratio estimates generated by the power control loop in the receiver.

The above-mentioned problems remain unsolved even in the above-mentioned Publications.

### SUMMARY OF THE INVENTION

In view of the above-mentioned problems in the conventional turbo decoder used in CDMA mobile communications systems, we have appreciated that it is desirable to provide a method of decoding turbo-encoded, received data in the CDMA system, which is capable of enhancing decoding performance with a minimum increase in hardware and software, exerting a minimum influence on the processing rate, and accomplishing a small-sized circuit with a light weight and small power consumption.

In a first aspect of the present invention, there is provided a receiver for decoding turbo-encoded, received data in a CDMA Code Division Multiple Access system, which carries out, based on a signal to interference ratio, closed-loop power control of a data transmitter, the receiver comprising: (a) a power controller for weighting reverse-diffused, received data, based on the signal to interference ratio and (b) a turbo decoder which carries out an ACS operation or a comparison/selection operation in a process of updating an alpha metric, a process of updating a beta metric, and a process of computing a likelihood, for the thus weighted, received data, and compensates for the results of the ACS operation or the comparison selection operation, in at least one of the process of updating the alpha metric, the process of updating the beta metric, and the process for computing the likelihood, based on a predetermined value associated with the difference generated when the ACS operation or the comparison/selection operation is carried out.

A corresponding method is also provided.

In still another aspect of the present invention, there is provided a combination of a turbo encoder for turbo-encoding data to be transmitted, and the above-mentioned receiver.

The advantages obtained by the aforementioned present invention will be described hereinbelow.

In accordance with the present invention, since data to be input into the turbo decoder includes data which has been weighted in accordance with the signal to interference ratio, it would be possible to fabricate a Jacobian table used for compensating for the results of updating the alpha metric, updating the beta metric, and calculation of the log likelihood, without data such as noise variance σ² and signal component Es being included in the table.

Accordingly, it is possible to accomplish a calculation equivalent to that of the BCJR algorithm with a minimum influence on the processing rate, with just a minimum increase in hard ware. Hence, the present invention makes it possible in the CDMA mobile communication system to minimize the power necessary for a transmitter to transmit signals, increase the capacity of the system to thereby increase the number of subscribers, and enhance the quality in receiving signals.

### BRIEF DESCRIPTION OF THE DRAWINGS

FIG. 1 is a block diagram of an example of a receiver in a CDMA mobile communication system;
FIG. 2 is a block diagram of an example of a turbo encoder including a plurality of component encoders arranged in parallel with one another;
FIG. 3 is a block diagram of an example of a turbo decoder which decodes data having been turbo-encoded by the turbo encoder illustrated in FIG. 2;
FIG. 4 is a block diagram of an example of the turbo decoder illustrated in FIG. 3, the turbo decoder being comprised of a single soft-input and soft-output decoder by resource sharing;
FIG. 5 is a block diagram illustrating an example of the soft-input and soft-output decoder illustrated in FIGs. 3 and 4;
FIG. 6 is a block diagram of an example of the alpha metric producing circuit illustrated in FIG. 5;
FIG. 7 is a circuit diagram of an example of a Jacobian table comprised of logic circuits;
FIG. 8 is a graph showing the relation between the input and the output in the circuit illustrated in FIG. 7;
FIG. 9 is a block diagram of an example of the beta metric producing circuit illustrated in FIG. 5;
FIG. 10 is a block diagram of an example of the circuit for computing the log likelihood, illustrated in FIG. 5;
FIG. 11 is a block diagram of an example of a turbo encoder including a plurality of component encoders arranged in series with one another.
FIG. 12 is a block diagram of an example of a turbo decoder which decodes data having been turbo-encoded by the turbo encoder illustrated in FIG. 11.
FIG. 13 illustrates examples of recording media in which a program for carrying out the method of decoding turbo-encoded data is to be stored.

### DESCRIPTION OF THE PREFERRED EMBODIMENTS

Preferred embodiments in accordance with the present invention will be explained hereinbelow with reference to drawings.

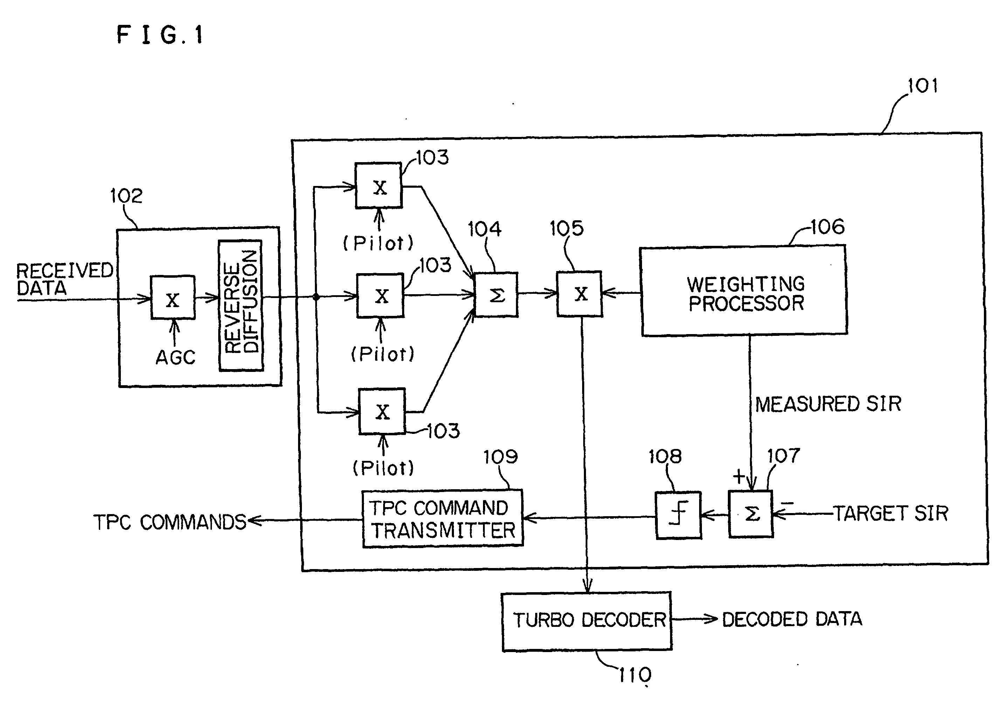

FIG. 1 is a block diagram of an example of a receiver used in a CDMA mobile communication system. FIG. 1 illustrates the structure of a part in the receiver which carries out steps to be carried out after reverse diffusion.

In FIG. 1, received data is subject to automatic gain control (AGC) and reverse-diffusion in a reverse-diffusion processor 102, and then, is input into a power controller 101 comprised of a digital signal processor (DSP).

The power controller 101 is comprised of a plurality of complex multipliers 103 each associated with each of a plurality of fingers (three fingers in FIG. 1), an in-phase adder 104 which rake-combines received data which are made to be in-phase with one another in the complex multipliers 103, a weighting processor 106 which measures the signal interference ratio (SIR), and computes weighting coefficients to be added to the rake-combined signals, a multiplier 105 which multiplies the weighting coefficients computed in the weighting processor 106, with the rake-combined, received data, a subtracter 107 which compares an actually measured SIR to a target SIR, a comparator 108 which converts the results of comparison carried out by the comparator 108, into binary code, and a TPC command transmitter 109 which transmits a TPC command to control the power of a transmitter in accordance with the results of the comparison carried out by the comparator 108.

A turbo decoder 110 which decodes turbo-encoded data received as an output from the multiplier 105.

Herein, a signal interference ratio (SIR) means the ratio of the power of a received signal to the interference power, including the power of background noise.

The complex multiplier 103 multiplies the reverse-diffused, received data with a conjugate complex number of a pilot symbol obtained by estimation of channels, in each pass. The received data arranged to be in-phase in the complex multiplier 103 are synthesized in the in-phase adder 104. That is, a plurality of the complex multipliers 103 and the in-phase adder 104 cooperate with each other to accomplish maximum ratio rake synthesis.

The weighting processor 106 measures the signal power (S) and the interference power (I) in each pass through the use of pilot symbols, and computes a measured SIR value having been rake-combined, based on the signal power and interference power.

The interference power may be measured by averaging the power associated with a plurality of slots, through a primary filter using a forgetting factor.

The weighting processor 106 computes a weighting coefficient defined in the following equation (6), for instance:${\text{Q × 2 × (Sa)}}^{\text{1/2}} \text{/(Ia)}$

In the equation (6), Q indicates a constant used for scaling the dynamic range of the output of the in-phase adder 104, which output is soft decision data for judgment; Sa indicates signal power per slot, and Ia indicates interference power per slot.

In the conventional method, rake-combined received data is transmitted to the turbo-decoder 110 without processing the rake-combined received data. In contrast, in accordance with the present embodiment, the multiplier 105 multiplies the rake-combined received data with a weighting coefficient used for controlling the power of the data transmitter, and transmits the thus weighted received data to the turbo decoder 110.

The power controller 101 controls the power of the data transmitter in each of the slot periods so as to coincide the actually measured SIR with the target SIR. To this end, the subtracter 107 compares the actually measured SIR to the target SIR, and transmits the results of the comparison to the comparator 108. The comparator 108 converts the comparison results received from the subtracter 107, into binary code, and thus produces binary code for input to the TPC command transmitter 109. The TPC command transmitter 109 produces TPC commands by which the power of the data transmitter is increased or decreased, in accordance with the output signals transmitted from the comparator 108, inserts the thus produced TPC commands into a power control bit mapped in a frame of a descending link, and transmits the TPC commands.

The above-mentioned closed-loop control of the power of the data transmitter is carried out in each slot. That is, the measured value of the received signal power and the measured value of the interference power which have been weighted are updated in each slot period.

A weighting coefficient added to the received signal in the weighting processor 106 is not limited to the coefficient defined in accordance with the above-mentioned equation (6). The weighting coefficient could be dependent on the gamma metric.

Hereinbelow is explained how the weighting coefficient is selected in the process of updating the alpha metric computed in the turbo decoder. A base of log is determined as a value associated with a predetermined Q-value.

First, it is assumed that two alpha metrics selected on a trellis at that time are expressed as α₁ and α₂, and the values of the alpha metrics in the log domain in which the base is set equal to a predetermined constant A, are expressed as α_{log1} and α_{log2}. That is, α₁ and α₂ are expressed as follows.${\text{α}}_{\text{1}} {\text{= A α}}^{\text{log1}}$${\text{α}}_{\text{2}} {\text{= A α}}^{\text{log2}}$

In addition, it is assumed that gamma metrics associated with the alpha metrics on a trellis are expressed as γ₁ and γ₂, and values of the gamma metrics in the log domain are expressed as γ_{log1} and γ_{log2}. It is assumed that an alpha metric having been updated is expressed as α₃, and the value of the alpha metric α₃ in the log domain is expressed as α_{log3}.

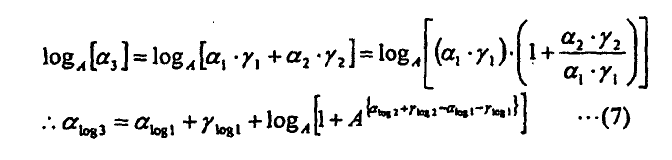

A term corresponding to the correction term fc (|δ₁ - δ₂|) in the equation (7) is as follows:

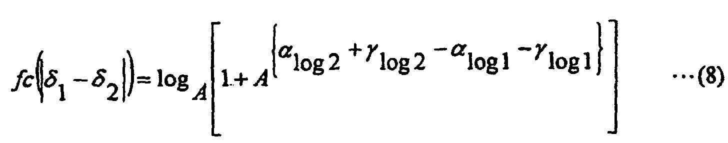

The gamma metric is expressed as follows:

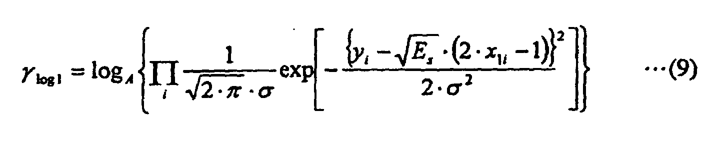

The equation (9) is substituted for the equation (8) to cancel common terms. As a result, the following equation (10) is obtained:

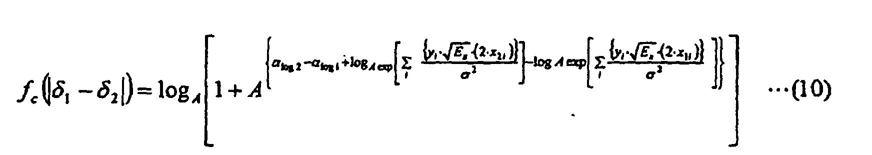

Herein, A is set equal to exp[1/Q], and the received data having been weighted is expressed as Yi which is determined as follows:$\text{A = exp [1/Q]}$${\text{Y}}_{\text{i}} \text{=} {\text{y}}_{\text{i}} \text{·} \text{Q} \text{·2·} \frac{\sqrt{{\text{E}}_{\text{s}}}}{{\text{σ}}^{\text{2}}}$

As a result, the following equation (12) is obtained:

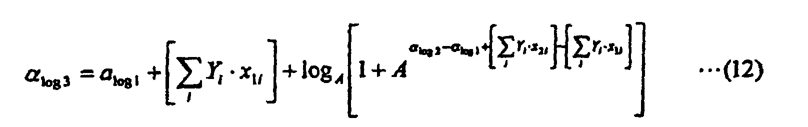

Accordingly, a term corresponding to the correction term fc (| δ₁ - δ₂|) in the equation (12) is expressed as follows:

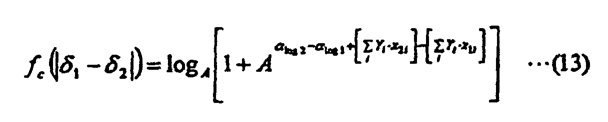

Thus, the correction term fc (|δ₁ - δ₂|) can be computed without including the noise variance σ² and signal component Es therein, both of which vary in accordance with fading.

The difference in the trellis corresponding to the sum of the alpha metric and the beta metric is represented as follows.

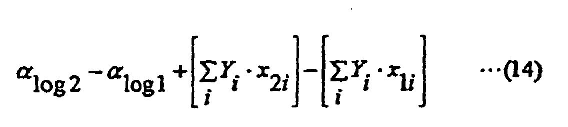

By using the difference defined in accordance with the equation (14), it would be possible to readily fabricate a Jacobian table of a small size to be used for the correction term fc (|δ₁ - δ₂|).

The gamma metric to be processed in the turbo decoder 110 is expressed as follows:

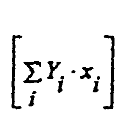

Since "x" is equal to 1 or 0, the above-mentioned gamma metric has a value only in a pass associated with x = 1 on the trellis, and the gamma metric is equal to 0 in a pass associated with x = 0. Here, the weighting coefficient defined in accordance with the equation (6) is used as the weighting coefficient.

It is assumed that the gamma metric is expressed in accordance with the equation (15):

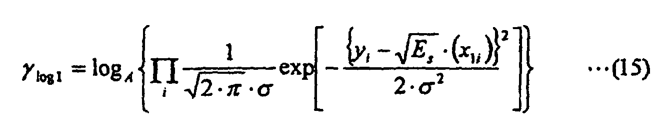

The equation (15) is substituted for the equation (8) to cancel common terms. As a result, the following equation (16) is obtained.

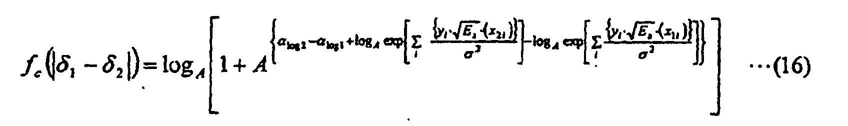

Herein, A is set equal to exp[1/Q], and the received data having been weighted is expressed as Yi which is determined as follows.$\text{A = exp [1/Q]}$${\text{Y}}_{\text{i}} \text{=} {\text{y}}_{\text{i}} \text{·} \text{Q} \text{·} \frac{\sqrt{\text{Es}}}{{\text{σ}}^{\text{2}}}$

Thus, there is obtained the following equation (18).

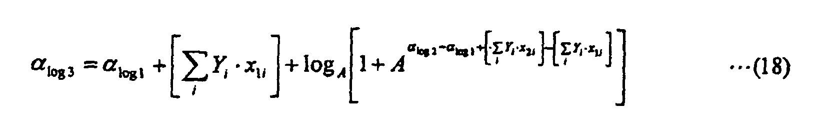

The difference on the trellis, associated with a sum of the alpha metric and the gamma metric is expressed as follows.

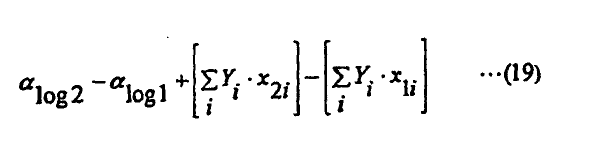

By using the difference defined in accordance with the equation (19), it would be possible to readily fabricate a Jacobian table of a small size to be used for the correction term fc (|δ₁ - δ₂|).

When the gamma metric is expressed in accordance with the equation (16), the weighting coefficient is expressed in accordance with the following equation (20):${\text{Q × (Sa)}}^{\text{1/2}} \text{/(Ia)}$

In the equation (20), Q indicates a constant used for scaling the dynamic range of the output from the in-phase adder 104, which output is soft decision data for judgment, Sa indicates signal power per slot, and Ia indicates interference power per slot.

The gamma metric to be processed in the turbo decoder 110 is expressed as follows:

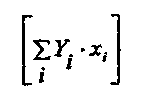

Since "x" is equal to -1 or +1, the above-mentioned gamma metric could have significant values in paths associated with x = -1 and x = +1 on the trellis.

In the above-mentioned case, the gamma metric is assumed to have Gaussian distribution. However, it should be noted that the gamma metric may be designed to have Rayleigh distribution.

In the first embodiment, the closed-loop power control based on the measured SIR and the process of weighting the rake combined received data is carried out in firmware defined by a digital signal processor, and the process of updating the alpha metric, the process of updating the beta metric, both including the above-mentioned Jacobian table, and the calculation of likelihood are accomplished by hardware.

Accordingly, since the received data to be input into the turbo decoder 110 includes weighted data about the interference power and signal power, it would be possible to carry out a calculation which is equivalent to the BCJR algorithm, through the turbo decoder 110, without using data such as the noise variance σ² and signal component Es.

In addition, since it is not necessary for the power controller 101 to transmit data about the noise variance σ² and signal component Es to the turbo decoder 110, it is possible to reduce the signal lines through which the power controller 101 and the turbo decoder 110 are electrically connected to each other.

Hereinbelow is explained the structure of the turbo encoder and the turbo decoder. The process of updating the alpha metric, the process of updating the beta metric, both including the Jacobian table, and the calculation of likelihood, which are to be carried out by the turbo decoder, can be carried out by hardware comprised of logic gates and memories.

Turbo encoders are grouped into a parallel arrangement type in which a plurality of component encoders are arranged in parallel with one another, and a series arrangement type in which a plurality of component encoders are arranged in series with one another. Each of the component encoders is comprised of a recursive convolution encoder including a plurality of delay units and exclusive ORs (EX-OR).

First, hereinbelow are explained a parallel arrangement type turbo encoder, and a turbo decoder for decoding data encoded by a turbo encoder.

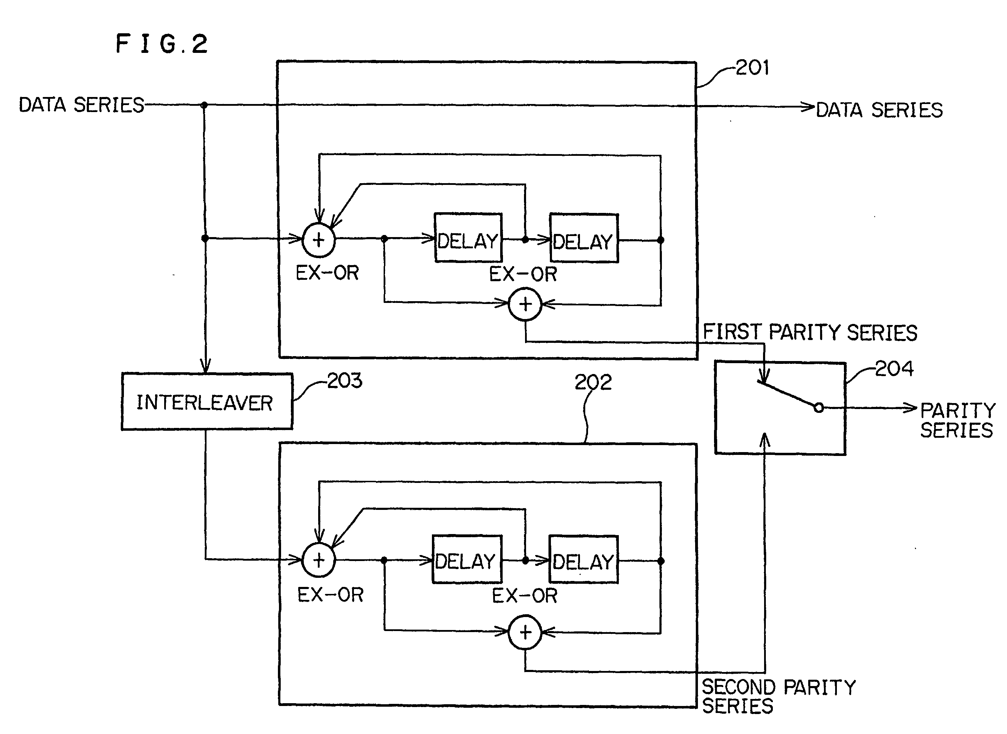

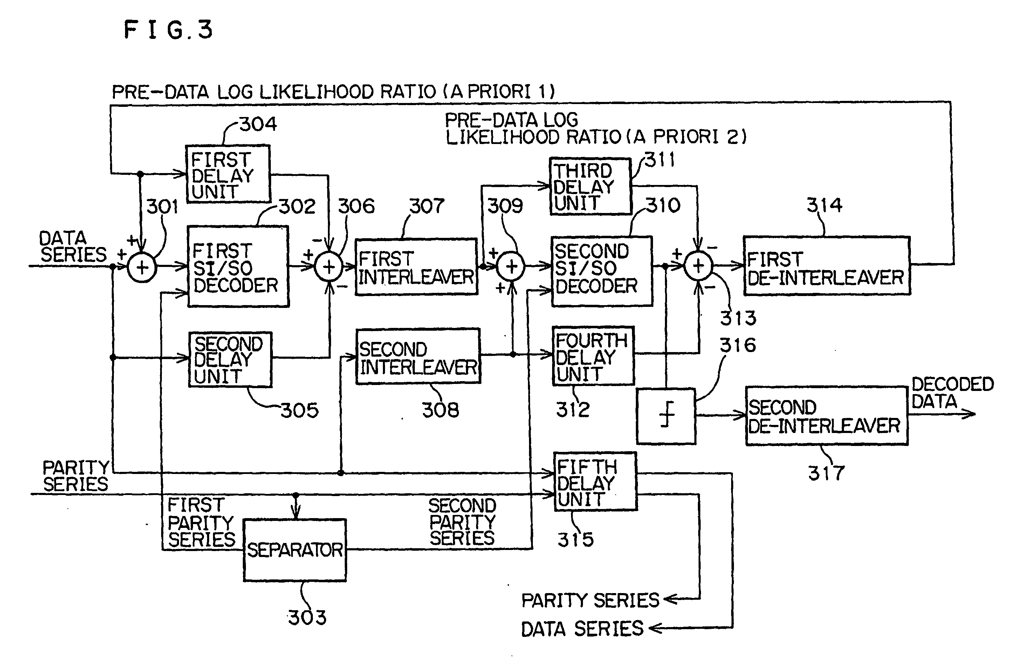

FIG. 2 is a block diagram illustrating an example of a parallel arrangement type turbo encoder, and FIG. 3 is a block diagram illustrating an example of a turbo decoder for decoding data turbo-encoded by the turbo encoder illustrated in FIG. 2.

As illustrated in FIG. 2, the parallel arrangement type turbo encoder is comprised of first and second component encoders 201 and 202 into which data series to be encoded is input, an interleaver 203 which re-arranges data series in accordance with a predetermined rule, and a switch 204 which switches between a first parity series transmitted from the first component encoder 201 and a second parity series transmitted from the second component encoder 202.

The first and second component encoders 201 and 202 are connected in parallel with each other. The second component encoder 202 receives the data series through the interleaver 203.

A turbo encoder usually includes a plurality of component encoders. The turbo encoder illustrated in FIG. 2 includes two component encoders 201 and 202. Though the interleaver 203 plays an important role in turbo-encoding data, since the operation of the interleaver 203 has nothing to do with the present invention, the interleaver 203 will not be explained in detail.

The first component encoder 201 transmits the data series and the first parity series together, and the second component encoder 202 transmits only the second parity series. The parity series may be transmitted from the first and second component encoders 201 and 202 with a part of the data being omitted by puncturing.

In the turbo encoder, since the data series, the first parity series and the second parity series are alternately transmitted through the switch 204, each of the series has a data transmission rate of 1/3 per unit period of time.

As illustrated in FIG. 3, the turbo decoder is comprised of a first soft-input and soft-output decoder 302 associated with the first component encoder 201; a second soft-input and soft-output decoder 310 associated with the second component encoder 202; a separator 303 which separates the parity series into the first parity series and the second parity series; a first interleaver 307 which re-arranges the bit arrangement in an output signal transmitted from the first soft-input and soft-output decoder 302; a second interleaver 308 which re-arranges the bit arrangement in the data series; a first de-interleaver 314 which arranges the bit arrangement, having been re-arranged by the first and second interleavers 307 and 308, back to their original bit arrangements; a first adder 301 which adds a later-mentioned a priori log likelihood ratio to the data series; a second adder 306 which adds the output of the first soft-input and soft-output decoder 302, the a priori log likelihood ratio, and the data series to one another; a first delay unit 304 which makes the output transmitted from the first soft-input and soft-output decoder 302 coincide with the delay of the a priori log likelihood ratio; a second delay unit 305 which makes the output of the first soft-input and soft-output decoder 302 coincide with the delay of the data series; a third adder 309 which adds the output of the first interleaver 307 to the output of the second interleaver 308; a fourth adder 313 which adds the output of the first soft-input and soft-output decoder 302, the output of the first interleaver 307, and the output from the second interleaver 308 to one another; a third delay unit 311 which makes a delay in the output of the first interleaver 307 coincide with the output of the second soft-input and soft-output decoder 310; a fourth delay unit 312 which makes the delay in the output of the second interleaver 308 coincide with the output of the second soft-input and soft-output decoder 310; a decision unit 316 which makes a hard decision, based on an output of the second soft-input and soft-output decoder 310; a second de-interleaver 317 which arranges the bit arrangement in the output of the decision unit 316, back to its original bit arrangement to thereby transmit decoded data; and a fifth delay unit 315 which delays the data series, the first parity series, and the second parity series by a predetermined degree.

Herein, the log likelihood ratio indicates a ratio in the form of log, defined as a ratio of the likelihood of a desired received symbol to the likelihood of the received symbol which is in contrary relation to the desired received symbol.

The data series to be decoded, the first parity series and the second parity series include not only data transmitted from the turbo encoder illustrated in FIG. 2, but also soft-judged received data containing errors caused by passing through transmission media. In addition, the data series is multiplied with a weighting coefficient by the multiplier 105 illustrated in FIG. 1.

The parity series input into the separator 303 is separated into the first parity series and the second parity series. The first parity series is input into the first soft-input and soft-output decoder 302, and the second parity series is input into the second soft-input and soft-output decoder 310.

As illustrated in FIG. 3, the data series and the a priori log likelihood ratio (a priori 1) are added to each other in the first adder 301, and then, are input into the first soft-input and soft-output decoder 302. The a priori log likelihood ratio (a priori 1) is designed to have an initial value of zero (0) so as not to have a preference. The first parity series separated from the parity series in the separator 303 is input also into the first soft-input and soft-output decoder 302. The soft-input and soft-output decoder 302 outputs log likelihood ratios each associated with each of the bits.

The second adder 306 subtracts both the a priori log likelihood ratio (a priori 1) synchronized with the output of the first soft-input and soft-output decoder 302 by means of the first delay unit 304 and the data series synchronized with the output of the first soft-input and soft-output decoder 302 by means of the second delay unit 305, from the log likelihood ratio transmitted from the first soft-input and soft-output decoder 302. As a result, the second adder 306 transmits a first extrinsic log likelihood ratio consisting of the log likelihood from which both the data series and the a priori log likelihood ratio (a priori 1) are removed.

The first extrinsic log likelihood ratio is stirred in the first interleaver 307, and then input into the third adder 309 together with the data series having been stirred by the second interleaver 308.

The second soft-input and soft-output decoder 310 receives the output of the third adder 309 and the second parity series separated from the parity series in the separator 303. The output of the first interleaver 307 defines the a priori log likelihood ratio (a priori 2) to be input into the second soft-input and soft-output decoder 310. The second soft-input and soft-output decoder 310 outputs log likelihood ratios associated with each of the bits in the interleaved data series.

The fourth adder 313 subtracts both the a priori log likelihood ratio (a priori 2) synchronized with the output of the second soft-input and soft-output decoder 310 by means of the third delay unit 311 and the interleaved data series synchronized with an output of the second soft-input and soft-output decoder 310 by means of the fourth delay unit 312, from the log likelihood ratio transmitted from the second soft-input and soft-output decoder 310. As a result, the fourth adder 313 transmits a second external data log likelihood consisting of the log likelihood ratio from which both the interleaved data series and the a priori log likelihood ratio (a priori 2) are removed.

The second extrinsic log likelihood ratio is re-arranged back to its original bit arrangement by the first de-interleaver 314, and then fed back to the first soft-input and soft-output decoder 302 as the a priori log likelihood ratio (a priori 1).

The data series, the first parity series and the second parity series are delayed by the fifth delay unit 315, and then fed back in synchronization with the next updating step.

Hereinafter, the data series is decoded by repeatedly carrying out the above-mentioned steps through the use of fed back data series and parity series. The log likelihood ratio transmitted from the second soft-input and soft-output decoder 310 is subject to a hard decision in the decision unit 316, and then re-arranged back to its original bit arrangement in the second de-interleaver 317, and thereafter, output as decoded data.

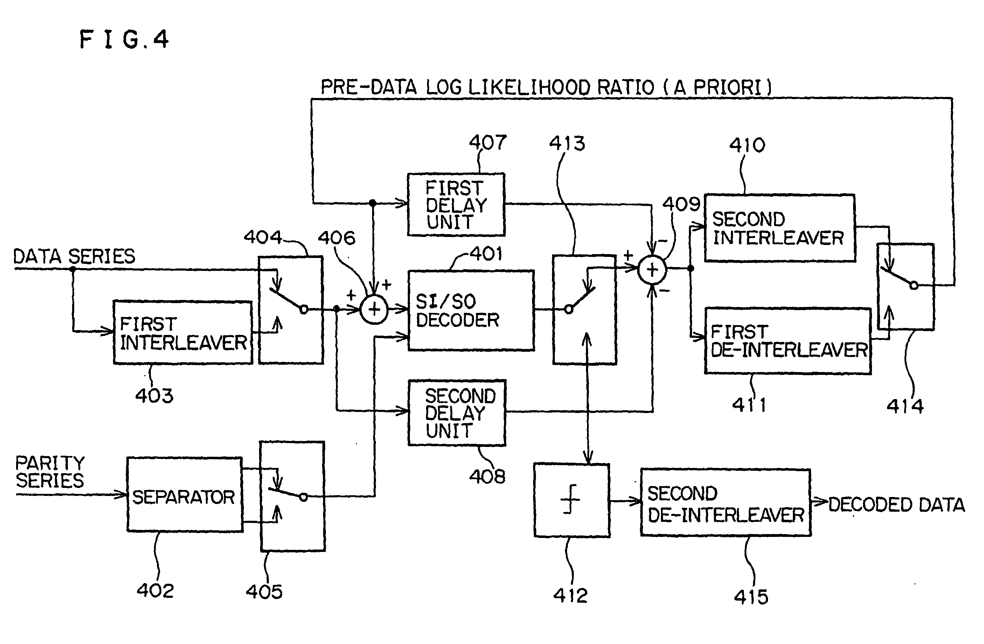

FIG. 4 is a block diagram of an example of the turbo decoder illustrated in FIG. 3. The illustrated turbo decoder is designed to be comprised of a single soft-input and soft-output decoder by resource sharing.

The turbo decoder illustrated in FIG. 4 is comprised of a soft-input and soft-output decoder 401 corresponding to the first and second component encoders 201 and 202 illustrated in FIG. 2; a separator 402 which separates the parity series into the first parity series and the second parity series; a first interleaver 403 which re-arranges the bit arrangement in the data series input into the soft-input and soft-output decoder 401; a first switch 404 through which one of the data series and the interleaved data series is input into the soft-input and soft-output decoder 401; a second switch 405 through which one of the first and second parity series transmitted from the separator 402 is input into the soft-input and soft output decoder 401; a first adder 406 which adds the a priori log likelihood ratio and the data series to each other; a first delay unit 407 which synchronizes the delay of the a priori log likelihood ratio with the output of the soft-input and soft-output decoder 401; a second delay unit 408 which synchronizes the delay of the data series with the output of the soft-input and soft-output decoder 401; a second adder 409 which adds the output of the soft-input and soft-output decoder 401, the a priori log likelihood ratio and the data series to one another; a second interleaver 410 which re-arranges the bit arrangement in the log likelihood transmitted from the second adder 409; a first de-interleaver 411 which re-arranges the bit arrangement of the log likelihood transmitted from the second adder 409, back to its original bit arrangement; a decision unit 412 which makes a hard decision, based on the output transmitted from the soft-input and soft-output decoder 401; a third switch 413 through which the output of the soft-input and soft-output decoder 401 is input into one of the second adder 409 and the decision unit 412; a fourth switch 414 which feeds one of the output of the second interleaver 410 and the output transmitted from the first de-interleaver 411 back to the soft-input and soft-output decoder 401 as the a priori log likelihood ratio; and a second de-interleaver 415 which re-arranges the bit arrangement in the output of the decision unit 412, back to its original bit arrangement, to thereby output decoded data.

The turbo decoder having such a structure as mentioned above, illustrated in FIG. 4, repeatedly feeds the extrinsic log likelihood ratio, the data series and the parity series all of which are transmitted from the soft-input and soft-output decoder 401, back to an input of the soft-input and soft-output decoder 401, similarly to the turbo decoder illustrated in FIG. 3.

The data series to be input into the soft-input and soft-output decoder 401 is allowed or disallowed to pass through the first interleaver 403 by the first switch 404 in dependence on whether the soft-input and soft-output decoder 401 is operating for the K-th time or for the L-th time, wherein K is an odd integer and L is an even number.

Similarly, the parity series is switched into the first or second parity series by means of the second switch 405, and then, input into the soft-input and soft-output decoder 401. Specifically, when the soft-input and soft-output decoder 401 is operating for the K-th time, the data series which is not interleaved, and the first parity series are input into the soft-input and soft-output decoder 401, and when the soft-input and soft-output decoder 401 operating for the L-th time, the data series having passed through the first interleaver 403, and the second parity series are input into the soft-input and soft-output decoder 401.

The second adder 409 subtracts both the a priori log likelihood ratio (a priori) synchronized with the output of the soft-input and soft-output decoder 401 by means of the first delay unit 407 and the data series synchronized with the output of the soft-input and soft-output decoder 401 by means of the second delay unit 408, from the log likelihood ratio transmitted from the soft-input and soft-output decoder 401. As a result, the second adder 409 transmits a first external data log likelihood consisting of the log likelihood ratio from which both the data series and the a priori log likelihood ratio are removed.

The extrinsic log likelihood ratio is input into either the second interleaver 410 or the first de-interleaver 411 in dependence on whether the soft-input and soft-output decoder 401 is operating for the K-th time or for the L-th time. The resultant output of either the second interleaver 410 or the first de-interleaver 411 is fed back to the first delay unit 407 and the soft-input and soft-output decoder 401 through the fourth switch 414 as the a priori log likelihood ratio.

Specifically, when the soft-input and soft-output decoder 401 operates for the K-th time, the output of the first de-interleaver 411 is fed back as the a priori log likelihood ratio, and when the soft-input and soft-output decoder 401 operates for the L-th times, the output of the second interleaver 410 is fed back as the a priori log likelihood ratio.

The first to fourth switches 404, 405, 413 and 414 are controlled in their operation by control signals transmitted from a sequencer (not illustrated).

Hereinafter, the data series is decoded by repeatedly carrying out the above-mentioned steps through the use of fed back data series and parity series. The log likelihood ratio transmitted from the soft-input and soft-output decoder 401 is subject to a hard decision in the decision unit 412, and then, re-arranged back to its original bit arrangement in the second de-interleaver 415, and thereafter, output as decoded data.

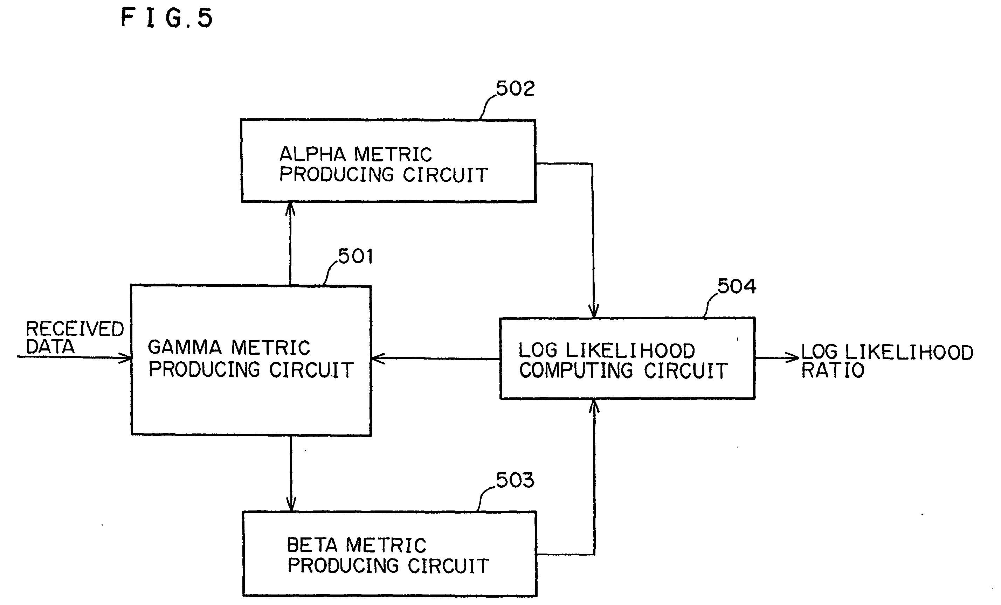

Hereinbelow is explained the soft-input and soft-output decoder which is a part of the turbo decoders illustrated in FIGs. 3 and 4. FIG. 5 is a block diagram of an example of the soft-input and soft-output decoder illustrated in FIG. 3 and 4.

The soft-input and soft-output decoder illustrated in FIG. 5 is comprised of a gamma metric producing circuit 501 which produces the gamma metric, an alpha metric producing circuit 502 which produces the alpha metric, a beta metric producing circuit 503 which produces the beta metric, and a log likelihood computing circuit 504 which computes a log likelihood ratio, based on the results of a calculation carried out by the alpha metric producing circuit 502 and the beta metric producing circuit 503.

Received data to be input into the soft-input and soft-output decoder is comprised of the data series resulting from multiplication of the rake-combined received data with the weighting coefficients, and correspond to the data series, the first parity series, and the second parity series all illustrated in FIGs. 3 and 4.

The turbo decoder illustrated in FIG. 3 is designed to have the two soft-input and soft-output decoders associated with the first and second parity series, and the turbo decoder illustrated in FIG. 4 is designed to have the single soft-input and soft-output decoder which alternately receives the first or second parity series. In contrast, in the soft-input and soft-output decoder illustrated in FIG. 5, the gamma metric producing circuit 501 is designed to include a memory (not illustrated) for storing the first and second parity series therein, and the first and second parity series is read alternately out of the memory.

In the turbo decoder illustrated in FIGs. 3 and 4, addition of the a priori log likelihood ratio and the data series to each other is carried out outside the soft-input and soft-output decoder. In contrast, the addition is carried out in the gamma metric producing circuit 501 in the soft-input and soft-output decoder illustrated in FIG. 5.

In the turbo decoder illustrated in FIGs. 3 and 4, the a priori log likelihood ratio and the data series are subtracted from the log likelihood ratio output from the soft-input and soft-output decoder, to thereby produce the external data likelihood ratio. The subtraction is carried out outside the soft-input and soft-output decoder. In contrast, the subtraction is carried out in the gamma metric producing circuit 501 in the soft-input and soft-output decoder illustrated in FIG. 5. Accordingly, the gamma metric including the computed a priori log likelihood ratio is input into both the alpha metric producing circuit 502 and the beta metric producing circuit 503.

An example of the gamma metric producing circuit 501 is disclosed, for instance, in Japanese Unexamined Patent Publication No. 2001-24521. Hence, the gamma metric producing circuit will not be explained in detail.

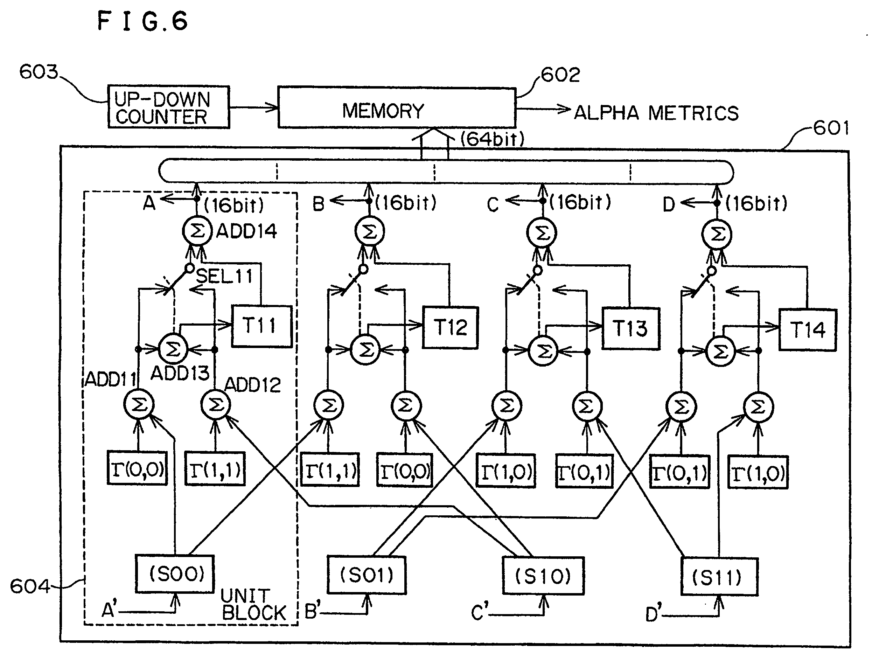

Hereinbelow is explained the alpha metric producing circuit 502 with reference to FIG. 6.

FIG. 6 is a block diagram of an example of the alpha metric producing circuit 502 illustrated in FIG. 5.

The illustrated alpha metric producing circuit 502 is comprised of an add-compare select (ACS) circuit 601 which carries out predetermined operations such as addition, subtraction and comparison on which is greater, based on gamma metrics Γ(0, 0), Γ(1, 1), Γ(1, 0) and Γ(0, 1) transmitted from the gamma metric producing circuits 501; a memory 602 for storing therein alpha metrics produced by the ACS circuit 601; and an up-down counter 603 comprised of an address counter for controlling addresses used for storing alpha metrics.

ACS circuit 601 illustrated in FIG. 6 is designed to have a structure to carry out calculation for a metric including four states (S00, S01, S10, S11), completely in parallel with one another. ACS circuit 601 is applicable to calculation of an alpha metric including eight states, for instance.

In FIG. 6, signal points A and A', signal points B and B', signal points C and C', and signal points D and D' are connected to each other, respectively, and the results of the calculation of the alpha metrics are fed back to a state register (S00, S01, S10, S11), and updated in the state register. The state register (S00, S01, S10, S11) in the ACS circuit 601 and each of the adders are connected through wires in accordance with a predetermined trellis chart.

ACS circuit 601 is comprised of the same four circuits which are different from one another only in their connection between the state register and the adder. Hereinbelow is explained an operation of the circuit located leftmost in FIG. 6. The circuit is designated as a unit block 604.

The output transmitted from the state register (S00), and a gamma metric Γ (0, 0) are input into an adder ADD 11 in the unit block 604. The output of the state register (S10), and a gamma metric Γ (1, 1) are input into an adder ADD 12 in the unit block 604.

An adder (or subtracter) ADD 13 receives the outputs of the adders ADD 11 and 12, and compares them to each other to detect which one is greater. The outputs of the adders ADD 11 and 12 are input into a selector SEL 11. The selector SEL 11 selects one of the outputs of the adders ADD 11 and 12 in accordance with results of the comparison carried out by the adder ADD 13, and transmits the selected output.

The adder ADD 13 also outputs the absolute value of the difference between the output of the adder ADD 11 and the output of the adder ADD 12, to a Jacobian table T11.

The Jacobian table T11 is comprised of wired logics such that the following relation (21) is established:

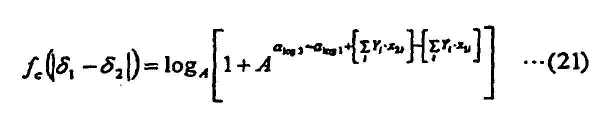

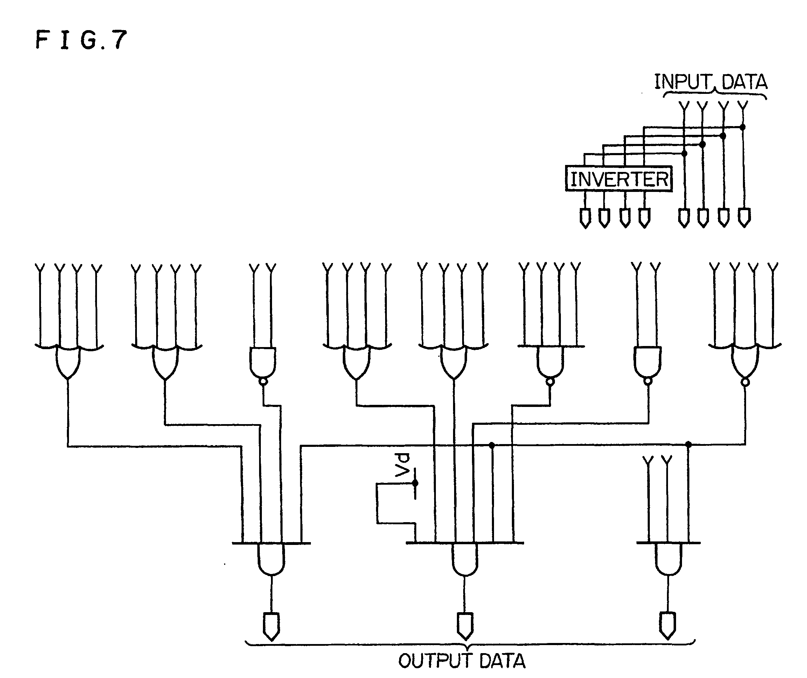

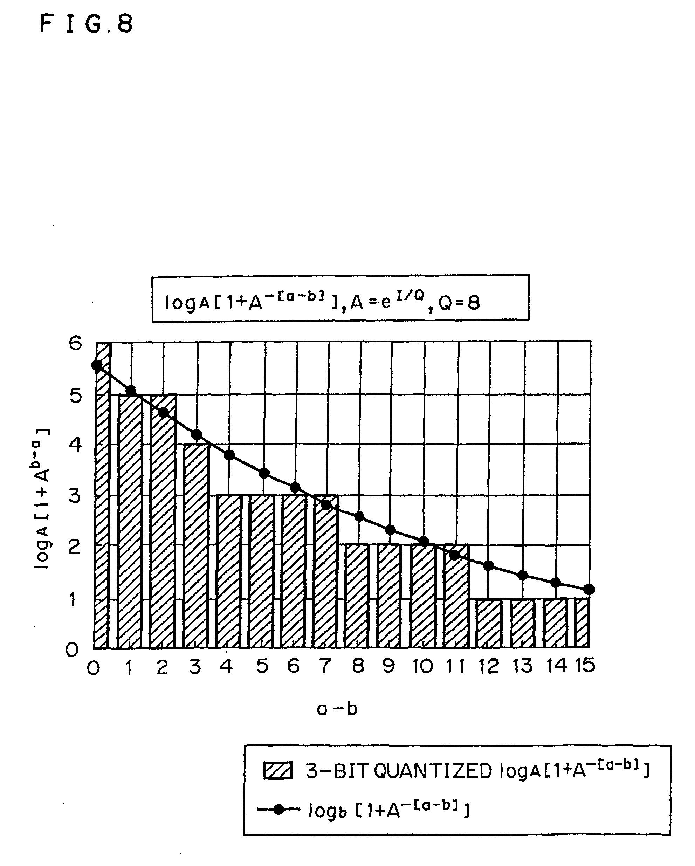

FIG. 7 illustrates an example of a Jacobian table comprised of wired logic circuits, and FIG. 8 illustrates a relation between input and output in the Jacobian table illustrated in FIG. 7.

The wired logic circuit illustrated in FIG. 7 decodes input data having 4 bits, and outputs corrected data having 3 bits. Though connection of input data and inverter output to a logic gate is omitted in FIG. 7, the connection is determined in accordance with I/O relation.

As illustrated in FIG. 8, for instance, when the wired logic circuit receives an input (a-b) equal to 7, the wired logic circuit outputs 3 as corrected data; when the wired logic circuit receives an input (a-b) equal to 12, the wired logic circuit outputs 1 as corrected data.

The output of the selector SEL 11 and corrected data transmitted from the Jacobian table T11 are added to each other in an adder ADD 14. Calculation carried out in the adder ADD 14 corresponds to the calculation defined in accordance with the following equation (22):

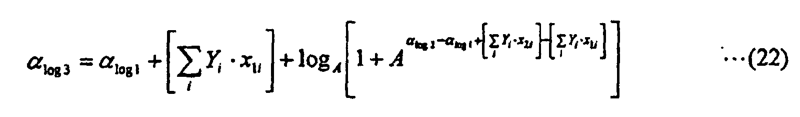

The results of the calculation carried out by the adder ADD 14 are stored in the memory 602, and further, fed back to the state register (S00).

The up-down counter 603 has a count width corresponding to a data bit length in a frame to be processed, and is incremented in each of data bits. The final bit in a frame to be processed defines a final address.

Data stored in the memory 602 is transmitted to the log likelihood computing circuit 504 at a predetermined timing.

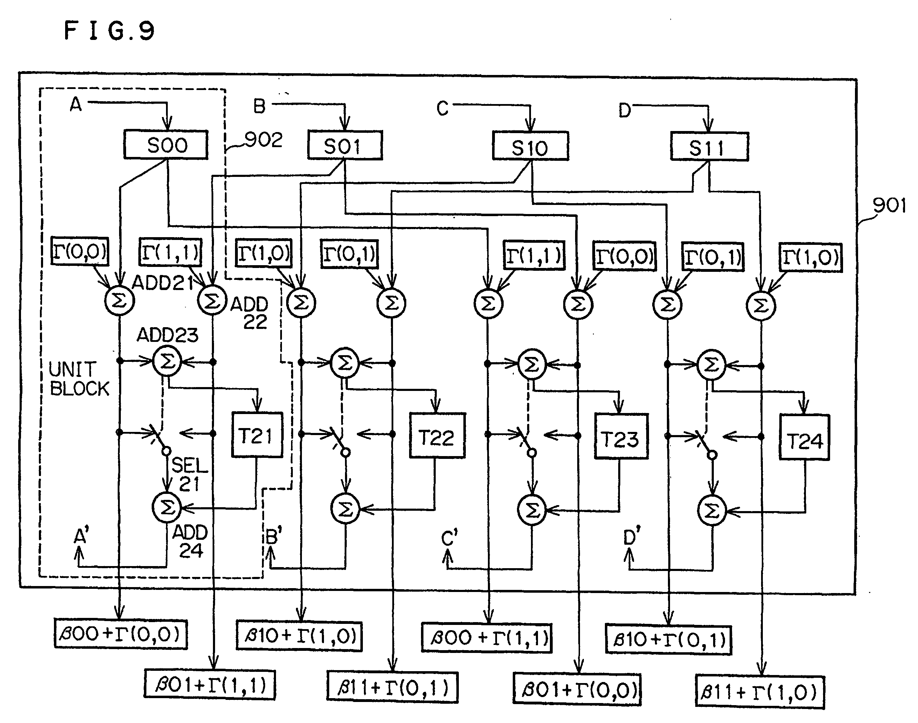

Hereinbelow is explained the beta metric producing circuit 503 illustrated in FIG. 5, with reference to FIG. 9. FIG. 9 is a block diagram of an example of the beta metric producing circuit 503 illustrated in FIG. 5.

The illustrated beta metric producing circuit 503 is designed to include an ACS circuit 901 which carries out a calculation, based on the alpha and gamma metrics Γ(0, 0), Γ(1, 1), Γ(1, 0) and Γ(0, 1).

The alpha metric producing circuit 502 illustrated in FIG. 6 stores metrics in each of the states, in the memory 602. In contrast, the beta metric producing circuit 503 stores only the metric produced at a target time, in the state register (S00, S01, S10, S11) for updating. This is because the direction in which the alpha metric is updated is contrary to the direction in which the beta metric is updated. For a likelihood associated with a data bit at a target time, it would be necessary to prepare both the alpha and beta metrics associated with the target time. To this end, at least one of the alpha and beta metrics has to include a memory.

In the alpha metric producing circuit 502 illustrated in FIG. 6 and the beta metric producing circuit 503 illustrated in FIG. 7, the results of the calculation of the alpha metrics are stored in a memory, and the likelihood is computed in synchronization with updating beta metrics. Alternatively, the results of the calculation of beta metrics may be stored in a memory, and the likelihood may be computed in synchronization with updating alpha metrics

Similarly to the alpha metric producing circuit 502 illustrated in FIG. 6, the beta metric producing circuit 503 illustrated in FIG. 9 is designed to have a structure to carry out calculation for a metric including four states (S00, S01, S10, S11), completely in parallel with one another. However, it should be noted that the beta metric producing circuit 503 is applicable to calculation of an beta metric including eight states, for instance.

In FIG. 9, signal points A and A', signal points B and B', signal points C and C', and signal points D and D' are connected to each other, respectively, and the results of the calculation of the beta metrics are fed back to a state register (S00, S01, S10, S11), and updated in the state register. The state register (S00, S01, S10, S11) in ACS circuit 901 and each of adders are connected through wires in accordance with a predetermined trellis chart.

ACS circuit 901 is comprised of the same four circuits which are different from one another only in connection between the state register and the adder. Hereinbelow is explained an operation of the circuit located leftmost in FIG. 9. The circuit is designated as a unit block 902.

The output of the state register (S00), and a gamma metric Γ (0, 0) are input into an adder ADD 21 in the unit block 902. The output of the state register (S01), and a gamma metric Γ (1, 1) are input into an adder ADD 22 in the unit block 902.

An adder (or subtracter) ADD 23 receives the outputs of the adders ADD 21 and 22, and compares them to each other to detect which one is greater. The outputs of the adders ADD 21 and 22 are input into a selector SEL 21. The selector SEL 21 selects one of the outputs of the adders ADD 21 and 22 in accordance with results of comparison carried out by the adder ADD 23, and transmits the selected output.

The adder ADD 23 also outputs an absolute value of the difference between the output of the adder ADD 21 and the output of the adder ADD 22, to a Jacobian table T21.

The Jacobian table T21 is comprised of wired logic such that the following relation (23) is established:

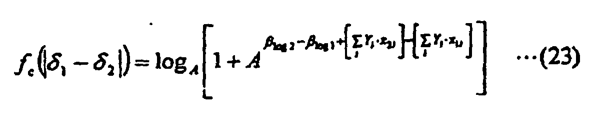

Similarly to the alpha metric producing circuit 502, the Jacobian table is comprised of the wired logic circuits illustrated in FIG. 7, and has such an I/O relation as illustrated in FIG. 8.

The output of the selector SEL 21 and corrected data transmitted from the Jacobian table T21 are added to each other in an adder ADD 24. The calculation carried out in the adder ADD 24 corresponds to the calculation defined in accordance with the following equation (24):

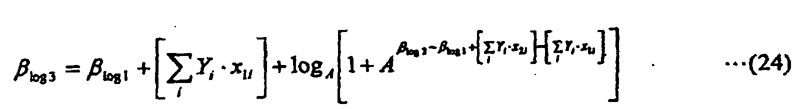

The results of the calculation carried out by the adder ADD 24 are fed back to the state register (S00). The output of the adder ADD 21, and the output of the adder ADD 22 are transmitted to the log likelihood computing circuit 504 illustrated in FIG. 5.

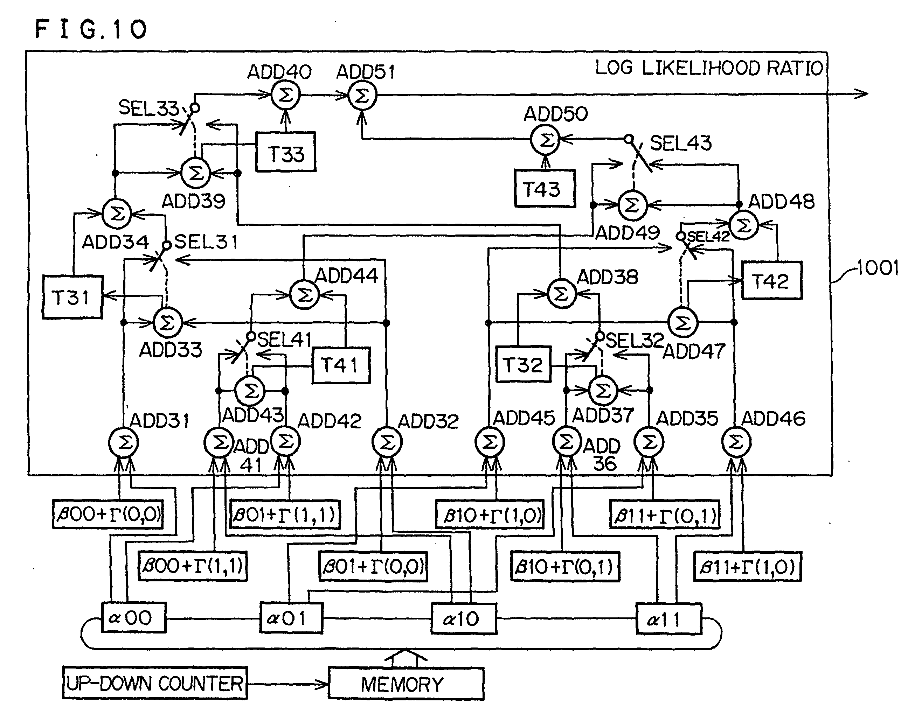

Hereinbelow is explained the log likelihood computing circuit 504 illustrated in FIG. 5, with reference to FIG. 10.

FIG. 10 is a block diagram of an example of the log likelihood computing circuit 504 illustrated in FIG. 5.

As illustrated in FIG. 10, the log likelihood computing circuit 504 is designed to include a likelihood computing circuit 1001 which computes a likelihood, based on the results of the calculation carried out by both the alpha metric producing circuit and the beta metric producing circuit.

The result of adding the gamma and beta metrics, transmitted from the beta metric producing circuit 503, and the alpha metric associated with the result, read out of the memory 602, are input into the likelihood computing circuit 1001. In general, alpha metrics are updated in the order of data bit arrangement in a received frame, and beta metrics are updated from the final bit. Hence, when the likelihood is computed in synchronization with the calculation carried out in the beta metric producing circuit, data is successively read out of the memory 602 firstly from a final address.

Though the present invention is applicable to a sliding window type likelihood computing circuit by replacing alpha metrics with new ones each time, there is use a one shot type likelihood computing circuit herein for the purpose of simplifying the explanation.

Since the likelihood computing circuit 1001 illustrated in FIG. 10 carries out calculation in the signal direction, the calculation may be made in pipeline. For instance, a flip-flop (F/F) circuit may be incorporated into the likelihood computing circuit 1001. Hence, calculation for one data bit is carried out per clock time.

The alpha metrics (α00, α01, α10, α11) read out of the memory 602, and the sum of the gamma and beta metrics transmitted from the beta metric producing circuit (β00 + Γ(0, 0), β00 + Γ(1, 1), β01 + Γ(1, 1), β01 + Γ (0, 0), β10 + Γ(1, 0), β10 + Γ(0, 1), β11 + Γ(0, 1), β11 + Γ(1, 0)) are processed in the likelihood computing circuit 1001 in accordance with a trellis chart, respectively.

In FIG. 10, hereinbelow is explained a trellis associated with data bit of "0".

A trellis associated with data bit of "0" corresponds to an output transmitted from an adder ADD 31, that is, the sum of α00 and β00 + Γ(0, 0) or an output transmitted from an adder ADD 32, that is, the sum of α10 and β01 + Γ(0, 0).

An adder (or subtracter) ADD 33 receives the outputs of the adders ADD 31 and 32, and compares them to each other to detect which one is greater. The outputs of the adders ADD 31 and 32 are input into a selector SEL 31. The selector SEL 31 selects one of the outputs of the adders ADD 31 and 32 in accordance with results of comparison carried out by the adder ADD 33, and transmits the selected output.

The adder ADD 33 also outputs the absolute value of the difference between the output of the adder ADD 31 and the output of the adder ADD 32, to a Jacobian table T31.

The Jacobian table T31 is represented in accordance with the equation (25), and is comprised of wired logics such that the correction term fc (|δ₁ - δ₂|) is defined in accordance with the following equation (26):

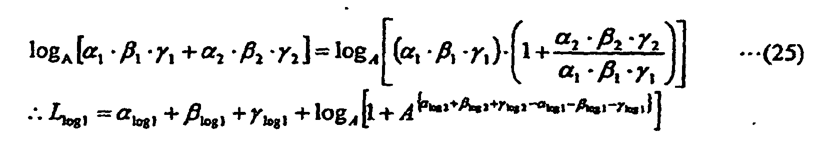

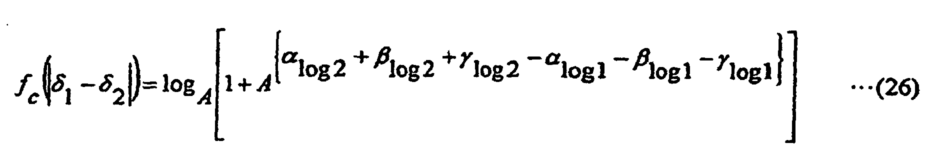

Similarly to the alpha metric producing circuit 502, the Jacobian table is comprised of the wired logic circuits illustrated in FIG. 7, and has such an I/O relation as illustrated in FIG. 8.

The output of the selector SEL 31 and corrected data transmitted from the Jacobian table T31 are added to each other in the adder ADD 34. The Calculation carried out in the adder ADD 34 corresponds to the calculation defined in the equation (25).

A trellis associated with data bit of "0" corresponds to the output of the adder ADD 35, that is, a sum of α01 and β11 + Γ(0, 1) or the output of the adder ADD 36, that is, a sum of α11 and β10 + Γ(0, 1).

An adder (or subtracter) ADD 37 receives the outputs of the adders ADD 35 and 36, and compares them to each other to detect which one is greater. The outputs of the adders ADD 35 and 36 are input into a selector SEL 32. The selector SEL 32 selects one of the outputs of the adders ADD 35 and 36 in accordance with the results of the comparison carried out by the adder ADD 37, and transmits the selected output.

The adder ADD 37 also outputs an absolute value of the difference between the output of the adder ADD 35 and the output of the adder ADD 36, to a Jacobian table T32.

The Jacobian table T32 is represented in accordance with the equation (27), and is comprised of wired logics such that the correction term fc (|δ₃ - δ₄|) is defined in accordance with the following equation (28):

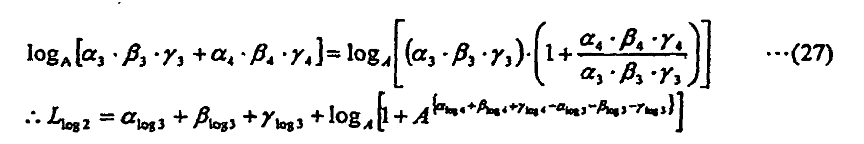

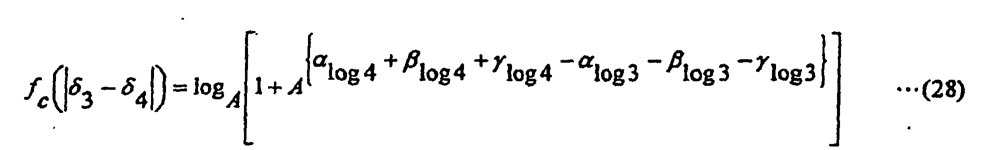

Similarly to the alpha metric producing circuit 502, the Jacobian table T32 is comprised of the wired logic circuits illustrated in FIG. 7, and has such an I/O relation as illustrated in FIG. 8.

The output transmitted from the selector SEL 32 and corrected data transmitted from the Jacobian table T32 are added to each other in the adder ADD 38. The calculation carried out in the adder ADD 38 corresponds to the calculation defined in the equation (27).

The above-mentioned trellis associated with a data bit of "0" are combined with each other. Specifically, an adder (or subtracter) ADD 39 receives outputs transmitted from the adders ADD 34 and 38, and compares them to each other to detect which one is greater. Outputs transmitted from the adders ADD 34 and 38 are input into a selector SEL 33. The selector SEL 33 selects one of the outputs transmitted from the adders ADD 34 and 38 in accordance with results of comparison carried out by the adder ADD 39, and transmits the selected output.

The adder ADD 39 also outputs the absolute value of the difference between the output transmitted from the adder ADD 34 and the output transmitted from the adder ADD 38, to a Jacobian table T33.

The Jacobian table T33 is represented in accordance with the equation (29), and is comprised of wired logics such that the correction term fc (|δ₁ - δ₂|) is defined in accordance with the following equation (30):

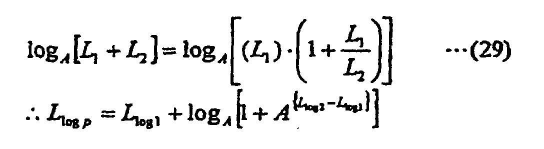

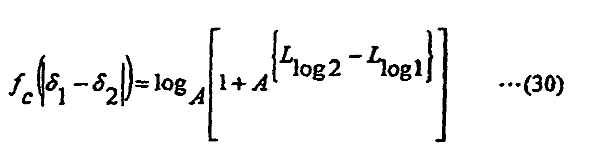

Similarly to the alpha metric producing circuit 502, the Jacobian table T33 is comprised of the wired logic circuits illustrated in FIG. 7, and has such an I/O relation as illustrated in FIG. 8.

The output of the selector SEL 33 and corrected data transmitted from the Jacobian table T33 are added to each other in the adder ADD 40. The Calculation carried out in the adder ADD 40 corresponds to the calculation defined in the equation (29).

In the above-mentioned equations (29) and (30), it is assumed that δ1 is equal to or greater than δ2 (δ1 ≧ δ2) in the terms selected by the selector SEL 33. That is, the equation (30) is established when L_{log1} is equal to or greater than L_{log2} (L_{log1} ≧ L_{log2}). Hence, if the conditions for selection are reversed, exponential terms of A have to be changed accordingly.

Hereinbelow is explained a trellis associated with data bit of "1".

A trellis associated with data bit of "1" corresponds to the output of the adder ADD 41, that is, the sum of α10 and β01 + Γ(1, 1) or the output of the adder ADD 42, that is, the sum of α00 and β01 + Γ(1, 1).

An adder (or subtracter) ADD 43 receives the outputs of the adders ADD 41 and 42, and compares them to each other to detect which one is greater. Outputs transmitted from the adders ADD 41 and 42 are input into a selector SEL 41. The selector SEL 41 selects one of the outputs of the adders ADD 41 and 42 in accordance with the results of the comparison carried out by the adder ADD 43, and transmits the selected output.

The adder ADD 43 also outputs the absolute value of the difference between the output of the adder ADD 41 and the output of the adder ADD 42, to a Jacobian table T41.

The Jacobian table T41 is represented in accordance with the equation (31), and is comprised of wired logics such that the correction term fc (|δ₁ - δ₂|) is defined in accordance with the following equation (32):

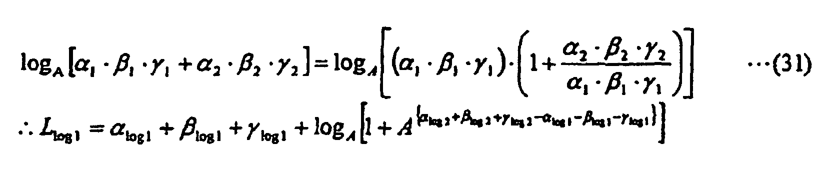

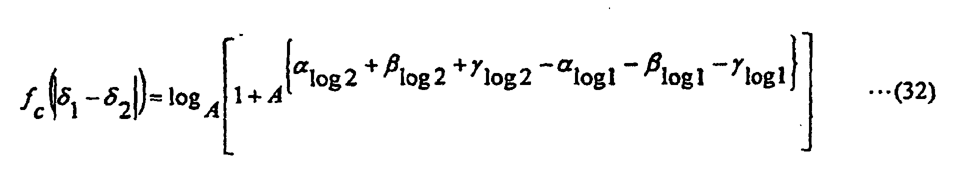

Similarly to the alpha metric producing circuit 502, the Jacobian table T41 is comprised of the wired logic circuits illustrated in FIG. 7, and has such a I/O relation as illustrated in FIG. 8.

The output of the selector SEL 41 and corrected data from the Jacobian table T41 are added to each other in the adder ADD 44. The calculation carried out in the adder ADD 44 corresponds to the calculation defined in the equation (31).

A trellis associated with data bit of "1" corresponds to the output of the adder ADD 45, that is, the sum of α01 and β10 + Γ (1, 0) or the output of the adder ADD 46, that is, the sum of α11 and β01 + Γ(1, 0).

An adder (or subtracter) ADD 47 receives the outputs of the adders ADD 45 and 46, and compares them to each other to detect which one is greater. The outputs of the adders ADD 45 and 46 are input into a selector SEL 42. The selector SEL 42 selects one of the outputs of the adders ADD 45 and 46 in accordance with the results of the comparison carried out by the adder ADD 47, and transmits the selected output.

The adder ADD 47 also outputs the absolute value of the difference between the output of the adder ADD 45 and the output of the adder ADD 46, to a Jacobian table T42.

The Jacobian table T42 is represented in accordance with the equation (33), and is comprised of wired logic such that the correction term fc (|δ₃ - δ₄|) is defined in accordance with the following equation (34).

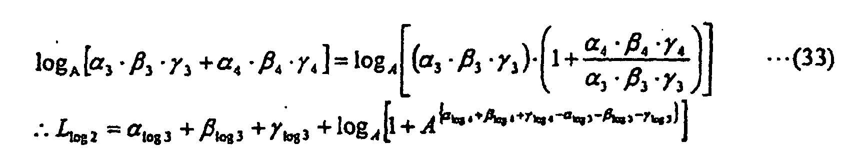

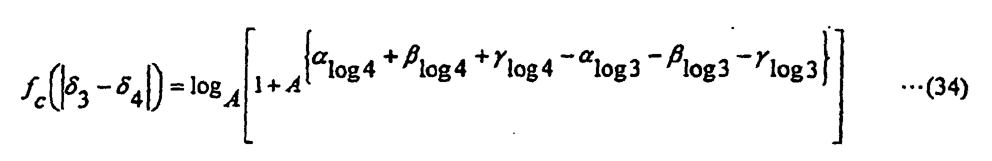

Similarly to the alpha metric producing circuit 502, the Jacobian table T42 is comprised of the wired logic circuits illustrated in FIG. 7, and has such an I/O relation as illustrated in FIG. 8.

The output of the selector SEL 42 and corrected data from the Jacobian table T42 are added to each other in the adder ADD 48. The calculation carried out in the adder ADD 48 corresponds to the calculation defined in the equation (33).

The above-mentioned trellis associated with a data bit of "1" are combined with each other. Specifically, an adder (or subtracter) ADD 49 receives the outputs of the adders ADD 44 and 48, and compares them to each other to detect which one is greater. The outputs of the adders ADD 44 and 48 are input into a selector SEL 43. The selector SEL 43 selects one of the outputs of the adders ADD 44 and 48 in accordance with the results of the comparison carried out by the adder ADD 49, and transmits the selected output.

The adder ADD 49 also outputs the absolute value of the difference between the output of the adder ADD 44 and the output of the adder ADD 48, to a Jacobian table T43.

The Jacobian table T43 is represented in accordance with the equation (35), and is comprised of wired logics such that the correction term fc (|δ₁ - δ₂|) is defined in accordance with the following equation (36):

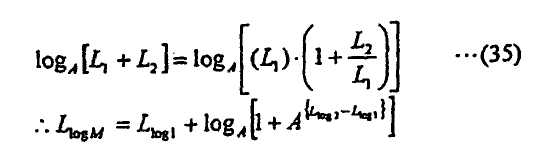

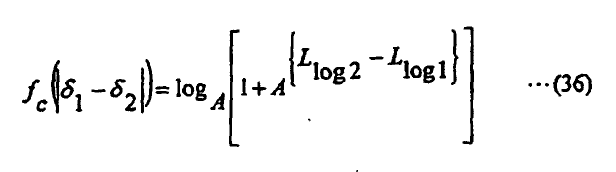

Similarly to the alpha metric producing circuit 502, the Jacobian table T43 is comprised of the wired logic circuits illustrated in FIG. 7, and has such an I/O relation as illustrated in FIG. 8.

The output transmitted from the selector SEL 43 and corrected data from the Jacobian table T43 are added to each other in the adder ADD 50. The calculation carried out in the adder ADD 50 corresponds to the calculation defined in the equation (35).

In the above-mentioned equations (35) and (36), it is assumed that δ1 is equal to or greater than δ2 (δ1 ≧ δ2) in the terms selected by the selector SEL 33. That is, the equation (36) is established when L_{log1} is equal to or greater than L_{log2} (L_{log1} ≧ L_{log2}). Hence, if the conditions for selection are reversed, exponential terms of A have to be changed accordingly.

The adder ADD 51 subtracts the output of the adder ADD 50, that is, the computation results L_{logM} associated with data bit of "1" from the output of the adder ADD 40, that is, the computation results L_{logP}, to thereby compute the log likelihood ratio LLR output from the soft-input and soft-output decoder.

That is, the log likelihood ratio LLR is expressed as follows.${\text{LLR = L}}_{\text{logP}} {\text{- L}}_{\text{logM}}$

The log likelihood ratio LLR is fed back also to the gamma metric producing circuit 502 illustrated in FIG. 5. As mentioned earlier, in the soft-input and soft-output decoder illustrated in FIG. 5, the pre-data likelihood ratio and the data series are subtracted from the log likelihood ratio LLR to thereby calculate the external data likelihood ratio in the gamma metric producing circuit 502. The thus calculated external data likelihood ratio is used as a next pre-data likelihood ratio.

Accordingly, by designing the alpha metric producing circuit, the beta metric producing circuit, and the log likelihood computing circuit to have a logic circuit defining the Jacobian table such as the one illustrated in FIG. 7, it would be possible to carry out computation equivalent to the BCJR algorithm, in a log domain.

If performances are not degraded, at least one of the alpha metric producing circuit 502, the beta metric producing circuit 503, and the log likelihood computing circuit 504 may be designed not to include the Jacobian table, that is, not to compensate for received data, in order to reduce the size of the circuit.

Hereinbelow is explained a series arrangement type turbo encoder and a turbo decoder for decoding data which is turbo-encoded by the series arrangement type turbo encoder.

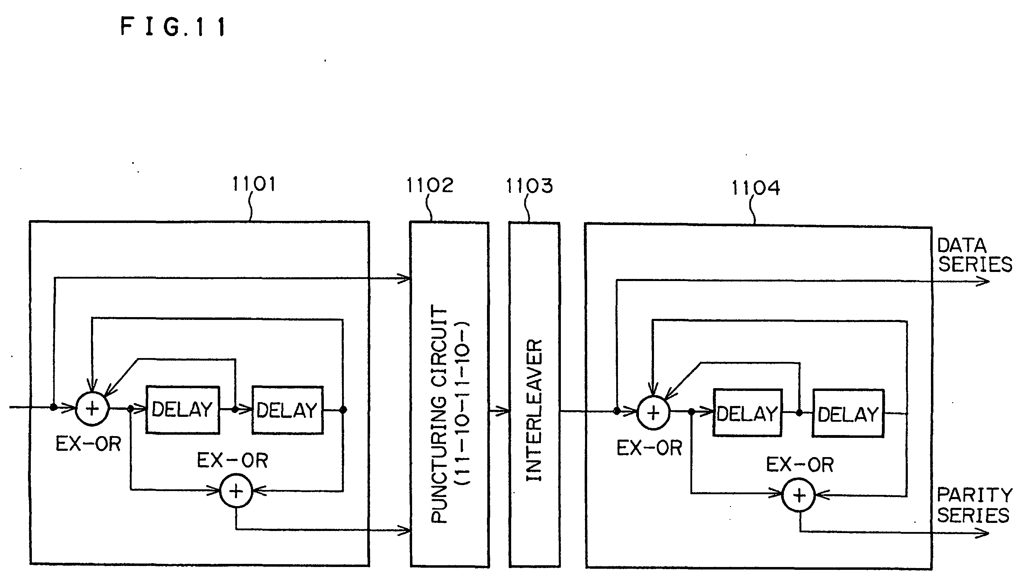

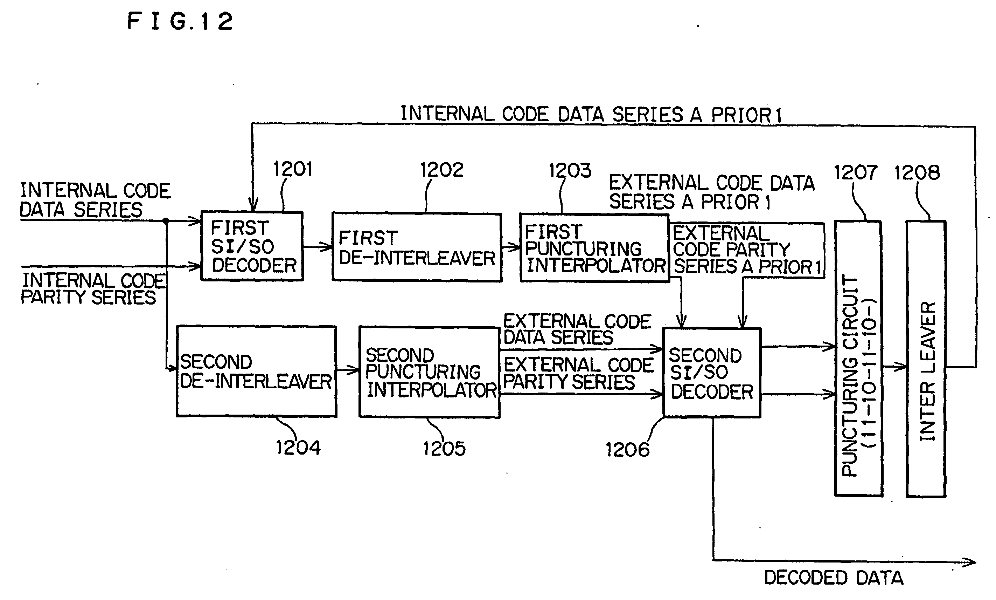

FIG. 11 is a block diagram of an example of a series arrangement type turbo encoder, and FIG. 12 is a block diagram of an example of a turbo decoder for decoding data encoded by the turbo encoder illustrated in FIG. 11.

The series arrangement type turbo encoder illustrated in FIG. 11 is comprised of an external encoder 1101 including at least one component encoder into which data series to be encoded are input, a puncturing circuit 1102 which punctures the data series and the parity series both transmitted from the external encoder 1101, an interleaver 1103 which re-arranges the bit arrangement in the data series and the parity series each in accordance with a predetermined rule, and an internal encoder 1104 including at least one component encoder and receiving the data series from the interleaver 1103.

The internal encoder 1104 and the external encoder 1101 both illustrated in FIG. 11 are designed to have the same structure. The data series and the parity series both transmitted from the external encoder 110 are input into the internal encoder 1104 through the puncturing circuit 1102 and the interleaver 1103.

A series arrangement type turbo encoder is usually designed to have a plurality of component encoders, similarly to the parallel arrangement type turbo encoder. The turbo encode illustrated in FIG. 11 is designed to have two component encoders.

Though the puncturing circuit 1102 and the interleaver 1103 play an important part in turbo encoding, their operation has nothing to do with the present invention, and hence, will not be explained in detail.

The puncturing circuit 1104 alternately removes bits in the parity series transmitted from the external encoder 1101. For instance, the sequence "11 -10-11-10-" indicates the significance of the data series and the parity series. Data "1" is output as it is, whereas data "0" is to be removed. That is, the second and fourth parity bits are removed in the above-mentioned sequence.

Because of alternate removal of parity bits by means of the puncturing circuit 1104, the data transmission rate in the external encoder 1101 is equal to 2/3 per unit period of time. However, since the data transmission rate in the internal encoder 1104 is equal to 1/2, the total data transmission rate is equal to 1/3 in a unit period of time.

The turbo decoder associated with the series arrangement type turbo encoder, illustrated in FIG. 12, is comprised of a first soft-input and soft-output decoder 1201 associated with the internal encoder 1104 illustrated in FIG. 11; a second soft-input and soft-output decoder 1206 associated with the external encoder 1101 illustrated in FIG. 11; a first de-interleaver 1202 which re-arranges the bit arrangement in the data series transmitted from the first soft-input and soft-output decoder 1201, back to its original bit arrangement; a second de-interleaver 1204 which re-arranges the bit arrangement in internal code data series or received data, back to its original bit arrangement; a first puncturing interpolator 1203 which zero-interpolates punctured bits, and outputs external code data series a-priori and external code parity series a-priori which are used for the second soft-input and soft-output decoder 1206 associated with the external encoder 1101; and a second puncturing interpolator 1205 which zero-interpolates punctured bits, and separates external code data series a-priori and external code parity series a-priori from each other which are used for the second soft-input and soft-output decoder 1206 associated with the external encoder 1101.

Internal code data series and internal code parity series illustrated in FIG. 12 are comprised of data transmitted from the turbo encoder illustrated in FIG. 11 and soft-judged received data including errors generated by passing through transmission media. The internal code data series and internal code parity series are data series with which a weighted coefficient is multiplied by the multiplier illustrated in FIG. 1.

The first soft-input and soft-output decoder 1201 receives the internal code data series, the internal code parity series, and the internal code data series a priori. Herein, the internal code data series a priori is designed to have an initial value of zero (0) so as not to have preference.

The first soft-input and soft-output decoder 1201 outputs an extrinsic log likelihood ratio consisting of a log likelihood ratio for each bit in the internal code data series, from which the data series and the internal code data series a priori are subtracted.

The extrinsic log likelihood ratio output from the first soft-input and soft-output decoder 1201 is re-arranged by the first de-interleaver 1202 back to its original bit arrangement, zero-interpolated by the first puncturing interpolator 1203, and is separated into the external code data series a priori and the external code data series a priori. The external code data series a priori and the external code data series a priori both output from the first puncturing interpolator 1203 are input into a second soft-input and soft-output decoder 1206.

The internal code data series is re-arranged by the second de-interleaver 1204 back to its original bit arrangement, zero-interpolated by the second puncturing interpolator 1205, and is separated into the external code data series and the external code data series. The external code data series and the external code data series both output from the second puncturing interpolator 1205 are input into the second soft-input and soft-output decoder 1206.

The external code data series a priori and the external code parity series a priori are used as a priori for the external code data series and the external code parity series, respectively.

The second soft-input and soft-output decoder 1206 outputs both an external code extrinsic log likelihood ratio consisting of a log likelihood ratio for each bit in the external code data series, from which the external code data series and the external code data series a priori are subtracted, and an external code external parity log likelihood ratio consisting of a log likelihood ratio for each bit in the external code parity series, from which the external code parity series and the external code parity series a priori are subtracted.

The external code extrinsic log likelihood ratios correspond to the output of the external encoder illustrated in FIG. 11. The external code external log likelihood ratios transmitted from the second soft-input and soft-output decoder 1206 are input into the puncturing circuit 1207 and then the interleaver 1208, and output from the interleaver 1208 as a priori for the internal code data series.

The thus produced internal code data series a priori is fed back to the first soft-input and soft-output decoder 1201, and is used as a priori for each of bits in the internal code data series.

Hereinafter, the same steps as mentioned above are repeatedly carried out to thereby make a hard decision to a final log likelihood ratio, and as a result decoded data is output.

The series arrangement type soft-input and soft-output decoder has basically the same structure as that of the parallel arrangement type soft-input and soft-output decoder. Accordingly, the Jacobian tables in both the soft-input and soft-output decoders have the same structure. However, the second soft-input and soft-output decoder 1206 illustrated in FIG. 12 is structurally different from the parallel arrangement type turbo decoder as follows.

The first soft-input and soft-output decoder 1201 receives a priori associated with the data series. On the other hand, the second soft-input and soft-output decoder 1206 receives not only a priori associated with the data series, but also a priori associated with the parity series. Accordingly, the second soft-input and soft-output decoder 1206 is necessary to have such a structure that not only the data series a priori but also the parity series a priori are considered when a gamma metric is to be produced.

In addition, the log likelihood computing circuit needs to additionally include a circuit for outputting a log likelihood ratio of the parity series. Thus, it is necessary for the log likelihood computing circuit to include such output circuits one for the data series and the other for the parity series. However, by adding a small circuit to the single log likelihood computing circuit by resource sharing, it would be possible to compute two log likelihood ratios in a single log likelihood computing circuit. Specifically, in the ACS circuit including the Jacobian table, the first stage subtraction circuit is commonly used for computing both a likelihood associated with a data bit and a likelihood associated with a parity bit, and the second and final stages subtraction circuits are fabricated separately for computing a likelihood associated with a data bit, and for computing a likelihood associated with a parity bit.

As mentioned above, the turbo decoder in accordance with the present invention makes it possible to accomplish computation equivalent to the BCJR algorithm merely by adding a small circuit thereto, without using algorithm accompanied by the problem of degradation in characteristics, such as Max-Log Map and SOVA.

Accordingly, in a CDMA mobile communication system, which can accomplish a high gain in encoding data, it is possible to minimize the power for transmitting data, increase the capacity of the system, and enhance the number of subscribers and the quality in receiving data.

In the present system, since rake-combined received data, with which a weighting coefficient used for power control is multiplied, is transmitted to a hardware-structured turbo decoder, it is no longer necessary to have, as interfaces, noise variance and signal power which are necessary for accomplishing algorithm defined with Jacobian logarithm, and it is also no longer necessary for the turbo decoder to include a memory to store such interfaces therein.

Furthermore, it would be possible to carry out computation equivalent to that of the BCJR algorithm which exerts less influence on the operation rate, merely by further having a hardware at a minimum degree, without the necessity of having a memory used for large-sized Jacobian table including noise variance and signal power as parameters.

The parallel arrangement type and series arrangement type turbo decoders may be used without modification in an interface.

In addition, since a weighting step is carried out in each of the slots, it is possible to carry out the weighting step at an interval equal to the interval for updating the transmission power control based on SIR measurement. This ensures minimum influence on the load exerted on DSP software, and accomplishment of the algorithm defined by Jacobian logarithm following a phasing pitch.

The above-mentioned method of decoding turbo-encoded, received data in CDMA system may be accomplished as a program including various commands, and be presented through a recording medium readable by a computer.

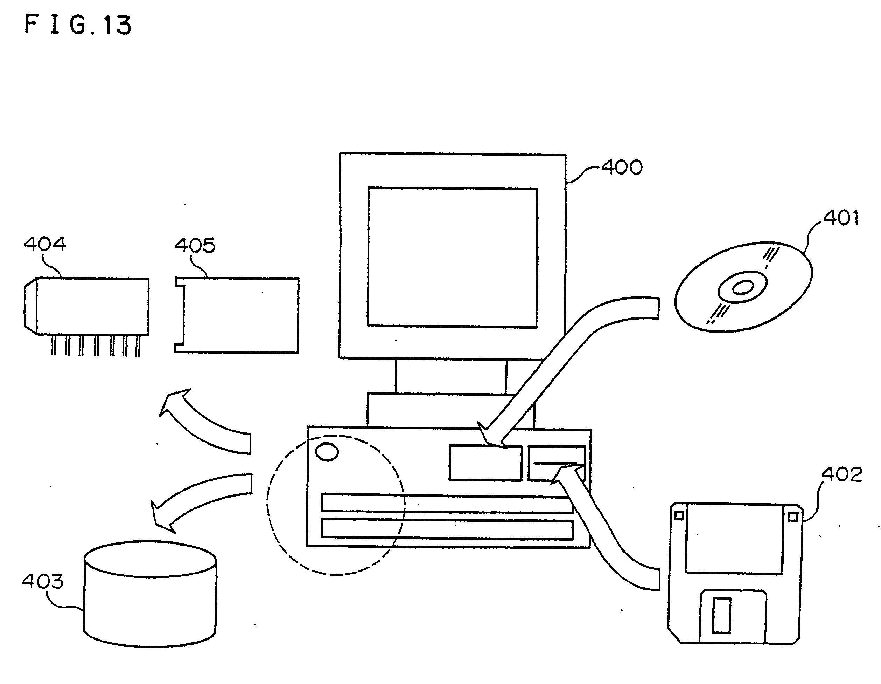

In the specification, the term "recording medium" means any medium on which data can be recorded. Examples of a recording medium are illustrated in FIG. 13.

The term "recording medium" includes, for instance, a disk-shaped recorder 401 such as CD-ROM (Compact Disk-ROM) or PD, a magnetic tape, MO (Magneto Optical Disk), DVD-ROM (Digital Video Disk-Read Only Memory), DVD-RAM (Digital Video Disk-Random Access Memory), a floppy disk 402, a memory chip 404 such as RAM (Random Access Memory) or ROM (Read Only Memory), EPROM (Erasable Programmable Read Only Memory), EEPROM (Electrically Erasable Programmable Read Only Memory), smart media (Registered Trade Mark), a flush memory, a rewritable card-type ROM 405 such as a compact flush card, a hard disk 403, and any other suitable means for storing a program therein.

A recording medium storing a program for accomplishing the above-mentioned apparatus may be accomplished by programming functions of the above-mentioned apparatuses with a programming language readable by a computer, and recording the program in a recording medium such as mentioned above.

A hard disc equipped in a server may be employed as a recording medium. It is also possible to accomplish the recording medium by storing the above-mentioned computer program in such a recording medium as mentioned above, and reading the computer program by other computers through a network.

As a computer 400, there may be used a personal computer, a desk-top type computer, a note-book type computer, a mobile computer, a lap-top type computer, a pocket computer, a server computer, a client computer, a workstation, a host computer, a commercially available computer, and electronic exchanger, for instance.

## Claims

1. A receiver for decoding turbo-encoded, received data in a CDMA Code Division Multiple Access system which carries out, based on a signal to interference ratio, closed-loop power control of a data transmitter,
the receiver comprising:
(a) a power controller (101) for weighting reverse-diffused, received data based on the signal to interference ratio; and
(b) a turbo decoder (110) which (i) carries out an ACS operation or a comparison/selection operation in a process of updating an alpha metric, a process of updating a beta metric, and a process of computing a likelihood, for the thus weighted, received data, and which (ii) compensates for the results of the ACS operation, or the comparison/selection operation in at least one of the process of updating the alpha metric, the process of updating the beta metric, and the process for computing the likelihood, based on a predetermined value associated with a difference generated when the ACS operation or the comparison/selection operation is carried out.

2. The receiver as set forth in claim 1, wherein the turbo decoder compensates for the results of the ACS operation, or the comparison/selection operation in the process of updating the alpha metric, the process of updating the beta metric, and the process for computing the likelihood.

3. The receiver as set forth in claim 1 or 2, wherein the power controller (101) carries out weighting reverse-diffused received data in each time slot of the received data.

4. The receiver as set forth in any of claims 1 to 3, wherein the power controller (101) multiplies X with the reverse-diffused received data, X being defined as a value which is proportional to the result of dividing the root of the signal power per slot by the interference power per slot.

5. The receiver as set forth in any preceding claim, wherein the turbo decoder (110) is comprised of:
(b1) a subtracting circuit which carries out the comparison/selection operation; and
(b2) a logic circuit which compensates for the results of the ACS operation, the logic circuit receiving the output, or the absolute value of the output, of the subtracting circuit, and outputting a predetermined value in accordance with the output.

6. The receiver as set forth in any of claims 1 or 4, wherein the power controller (101) weights reverse-diffused, received data through firmware defined by a processor for processing digital signals, and the turbo decoder (110) compensates for the results of the ACS operation through hardware including a logic gate.

7. A combination of a turbo encoder for turbo-encoding data to be transmitted, and a receiver as defined in any one of claims 1 to 6,
the turbo encoder comprising a plurality of component encoders arranged in parallel with one another.

8. The combination as set forth in claim 7, wherein the turbo encoder includes:
(a) first to N-th component encoders (201,202) each of which receives a data series to be encoded, wherein N is an integer equal to or greater than 2;
(b) an interleaver (203) connected to the component encoders in parallel to rearrange the data series in accordance with a predetermined rule, the interleaver receiving the data series and transmitting the data series to the second to N-th component encoders; and
(c) a switch (204) which switches the parity series transmitted from the component encoders.

9. A combination of a turbo encoder for turbo-encoding data to be transmitted, and a receiver as defined in any one of claims 1 to 6,
the turbo encoder comprising a plurality of component encoders arranged in series.

10. The combination as set forth in claim 9, wherein the turbo encoder includes:
(a) an outer encoder (1101) which receives data series to be encoded;
(b) a puncturing circuit (1102) which punctures data series and parity series both transmitted from the outer encoder;
(c) an interleaver (1103) which rearranges bit arrangement in the data series and the parity series each in accordance with a predetermined rule; and
(d) an inner (1104) encoder which receives the data series from the interleaver, and separates the data series and the parity series from each other.

11. A method of decoding turbo-encoded, received data in a CDMA Code Division Multiple Access receiver, which carries out, based on a signal-to-interference ratio, closed-loop power control of a data transmitter,
the method comprising the steps of:
(a) weighting reverse diffused, received data, based on the signal-to-interference ratio in a power controller (101);
(b) carrying out in a turbo decoder (110) an ACS operation or a comparison/selection operation in a process of updating an alpha metric, a process of updating a beta metric, and a process of computing a likelihood, for the thus weighted, received data; and
(c) compensating for the results of the ACS operation or the comparison/selection operation, in at least one of the process of updating the alpha metric, the process of updating the beta metric, and the process of computing the likelihood, based on a predetermined value associated with the difference generated when the ACS operation or the comparison/selection operation is carried out.

## Patentansprüche

1. Empfänger zum Decodieren von empfangenen Turbo-Code-Daten in einem CDMA- (Code Division Multiple Access) System, das auf der Basis eines Signal-Stör-Verhältnisses eine Leistungsregelung an einem Datensender durchführt, wobei der Empfänger Folgendes umfasst:
a) einen Leistungsregler (101), um empfangene Reverse-Diffusion-Daten auf der Basis des Signal-Stör-Verhältnisses zu gewichten; und
b) einen Turbo-Decoder (110), der (i) eine ACS-Operation oder eine Vergleich/Auswahl-Operation in einem Prozess des Aktualisierens einer Alpha-Metric, einem Prozess des Aktualisierens einer Beta-Metric und einem Prozess des Errechnens der Wahrscheinlichkeit für die so gewichteten empfangenen Daten durchführt, und der (ii) die Ergebnisse der ACS-Operation oder der Vergleich/Auswahl-Operation in dem Prozess des Aktualisierens der Alpha-Metric, dem Prozess des Aktualisierens der Beta-Metric und/oder dem Prozess des Errechnens der Wahrscheinlichkeit auf der Basis eines vorbestimmten Wertes in Verbindung mit einer Differenz kompensiert, die entsteht, wenn die ACS-Operation oder die Vergleich/Auswahl-Operation durchgeführt wird.

2. Empfänger nach Anspruch 1, bei dem der Turbo-Decoder die Ergebnisse der ACS-Operation oder der Vergleich/Auswahl-Operation in dem Prozess des Aktualisierens der Alpha-Metric, dem Prozess des Aktualisierens der Beta-Metric und/oder dem Prozess des Errechnens der Wahrscheinlichkeit kompensiert.

3. Empfänger nach Anspruch 1 oder 2, bei dem der Leistungsregler (101) die Reverse-Diffusion-Daten in jedem Zeitschlitz der empfangenen Daten gewichtet.

4. Empfänger nach einem der Ansprüche 1 bis 3, wobei der Leistungsregler (101) X mit den empfangenen Reverse-Diffusion-Daten multipliziert, wobei X als ein Wert definiert ist, der proportional zum Ergebnis der Division der Wurzel der Signalleistung pro Schlitz durch die Störleistung pro Schlitz ist.

5. Empfänger nach einem der vorherigen Ansprüche, bei dem der Turbo-Decoder (110) Folgendes umfasst:
(b1) eine Subtraktionsschaltung, die die Vergleich/Auswahl-Operation durchführt; und
(b2) eine Logikschaltung, die die Ergebnisse der ACS-Operation kompensiert, wobei die Logikschaltung den Ausgang oder den Absolutwert des Ausgangs der Subtraktionsschaltung empfängt und einen vorbestimmten Wert gemäß dem Ausgang ausgibt.

6. Empfänger nach einem der Ansprüche 1 bis 4, wobei der Leistungsregler (101) empfangene Reverse-Diffusion-Daten durch Firmware gewichtet, die von einem Prozessor zum Verarbeiten von digitalen Signalen definiert wird, und der Turbo-Decoder (110) die Ergebnisse der ACS-Operation durch Hardware kompensiert, die ein Logikgatter beinhaltet.

7. Kombination aus einem Turbo-Codierer zum Turbo-Codieren von zu sendenden Daten und einem Empfänger nach einem der Ansprüche 1 bis 6, wobei der Turbo-Codierer eine Mehrzahl von Komponentencodierern umfasst, die parallel zueinander angeordnet sind.

8. Kombination nach Anspruch 7, bei der der Turbo-Codierer Folgendes umfasst:
(a) einen ersten bis N-ten Komponentencodierer (201, 202), die jeweils eine zu codierende Serie von Daten empfangen, wobei N eine ganze Zahl größer als oder gleich 2 ist;
(b) einen Verschachteler (203), der parallel zu den Komponentencodierern geschaltet ist, um die Datenserie gemäß einer vorbestimmten Regel umzuordnen, wobei der Verschachteler die Datenserie empfängt und die Datenserie zu den zweiten bis N-ten Komponentencodierern sendet; und
(c) einen Schalter (204), der die von den Komponentencodierern gesendete Paritätsserie schaltet.

9. Kombination aus einem Turbo-Codierer zum Turbo-Codieren von zu sendenden Daten und einem Empfänger nach einem der Ansprüche 1 bis 6, wobei der Turbo-Codierer eine Mehrzahl von Komponentencodierern umfasst, die in Reihe zueinander angeordnet sind.

10. Kombination nach Anspruch 9, wobei der Turbo-Codierer Folgendes umfasst:
(a) einen äußeren Codierer (1101), der eine zu codierende Datenserie empfängt;
(b) eine Punktierungsschaltung (1102), die die Datenserie und die Paritätsserie punktiert, die beide von dem äußeren Codierer gesendet wurden;
(c) einen Verschachteler (1103), der die Bitanordnung in der Datenserie und der Paritätsserie jeweils gemäß einer vorbestimmten Regel umordnet; und
(d) einen inneren Codierer (1104), der die Datenserie von dem Verschachteler empfängt und die Datenserie und die Paritätsserie voneinander trennt.

11. Verfahren zum Decodieren von empfangenen Turbo-Code-Daten in einem CDMA- (Code Division Multiple Access) System, das auf der Basis eines Signal-Stör-Verhältnisses eine Leistungsregelung an einem Datensender durchführt, wobei das Verfahren die folgenden Schritte umfasst:
(a) Gewichten von empfangenen Reverse-Diffusion-Daten auf der Basis des Signal-Stör-Verhältnisses in einem Leistungsregler (101);
(b) Durchführen, in einem Turbe-Decoder (110), einer ACS-Operation oder einer Vergleich/Auswahl-Operation in einem Prozess des Aktualisierens einer Alpha-Metric, einem Prozess des Aktualisierens einer Beta-Metric und dem Prozess des Errechnens einer Wahrscheinlichkeit für die so gewichteten empfangenen Daten; und
(c) Kompensieren der Ergebnisse der ACS-Operation oder der Vergleich/Auswahl-Operation in dem Prozess des Aktualisierens der Alpha-Metric, dem Prozess des Aktualisierens der Beta-Metric und dem Prozess des Errechnens der Wahrscheinlichkeit auf der Basis eines vorbestimmten Wertes in Verbindung mit der Differenz, die entsteht, wenn die ACS-Operation oder die Vergleich/Auswahl-Operation durchgeführt wird.

## Revendications

1. Récepteur pour décoder des données reçues turbo codées dans un système d'accès multiple par code de répartition CDMA qui effectue, sur la base d'un rapport de signal sur interférence, le contrôle de puissance en boucle fermée d'un émetteur de données,
le récepteur comprenant :
(a) un contrôleur de puissance (101) pour pondérer des données reçues en diffusion inverse sur la base du rapport de signal sur interférence; et
(b) un turbo décodeur (110) qui (i) effectue une opération ACS ou une opération de comparaison/sélection dans un processus d'actualisation d'une métrique alpha, un processus d'actualisation d'une métrique bêta et un processus de calcul d'une vraisemblance, pour les données reçues ainsi pondérées, et qui (ii) compense les résultats de l'opération ACS ou de l'opération de comparaison/sélection, dans au moins l'un du processus d'actualisation de métrique alpha, du processus d'actualisation de métrique bêta et du processus de calcul de vraisemblance, sur la base d'une valeur prédéterminée associée à une différence générée lorsque l'opération ACS ou l'opération de comparaison/sélection est effectuée.

2. Le récepteur tel que stipulé dans la revendication 1, dans lequel le turbo décodeur compense les résultats de l'opération ACS ou de l'opération de comparaison/sélection dans le processus d'actualisation de la métrique alpha, le processus d'actualisation de la métrique bêta et le processus de calcul de la vraisemblance.

3. Le récepteur tel que stipulé dans la revendication 1 ou 2, dans lequel le contrôleur de puissance (101) effectue la pondération de données reçues en diffusion inverse dans chaque tranche de temps des données reçues.

4. Le récepteur tel que stipulé dans l'une quelconque des revendications 1 à 3, dans lequel le contrôleur de puissance (101) multiplie X par les données reçues en diffusion inverse, X étant défini comme une valeur qui est proportionnelle au résultat de la division de la racine de la puissance de signal par tranche, par la puissance d'interférence par tranche.

5. Le récepteur tel que stipulé dans l'une quelconque des revendications précédentes, dans lequel le turbo décodeur (110) est constitué :
(b1) d'une unité de soustraction qui effectue l'opération de comparaison/sélection; et
(b2) d'un circuit logique qui compense les résultats de l'opération ACS, le circuit logique recevant la sortie, ou la valeur absolue de la sortie du circuit de soustraction, et sortant une valeur prédéterminée conformément à la sortie.

6. Le récepteur tel que stipulé dans l'une quelconque des revendications 1 à 4, dans lequel le contrôleur de puissance (101) pondère des données reçues en diffusion inverse au moyen d'un microprogramme défini par un processeur de traitement de signaux numériques, et le turbo décodeur (110) compense les résultats de l'opération ACS au moyen d'un matériel incluant une porte logique.

7. Combinaison constituée d'un turbo codeur pour turbo coder des données à émettre et d'un récepteur tel que défini dans l'une quelconque des revendications 1 à 6,
le turbo codeur comprenant une pluralité de codeurs constituants disposés parallèlement les uns aux autres.

8. La combinaison telle que stipulée dans la revendication 7, dans laquelle le turbo codeur comprend :
(a) le premier jusqu'au Nième codeurs constituants (201, 202) dont chacun reçoit une série de données à coder, où N est un entier égal à ou plus grand que 2;
(b) un entrelaceur (203) connecté en parallèle aux codeurs constituants pour redisposer la série de données conformément à une règle prédéterminée, l'entrelaceur recevant la série de données et émettant la série de données au deuxième jusqu'au Nième codeurs constituants; et
(c) un commutateur (204) qui commute la série de parités émise par les codeurs constituants.

9. Combinaison constituée d'un turbo codeur pour turbo coder des données à émettre et d'un récepteur tel que défini dans l'une quelconque des revendications 1 à 6,
le turbo codeur comprenant une pluralité de codeurs constituants disposés en série.

10. La combinaison telle que stipulée dans la revendication 9, dans laquelle le turbo codeur comprend :
(a) un codeur externe (1101) qui reçoit une série de données à coder;
(b) un circuit de perforation (1102) qui perfore une série de données et une série de parités toutes les deux émises par le codeur externe;
(c) un entrelaceur (1103) qui redispose la disposition binaire dans la série de données et la série de parités chacune selon une règle prédéterminée; et
(d) un codeur interne (1104) qui reçoit la série de données de l'entrelaceur et sépare la série de données et la série de parités l'une de l'autre.

11. Méthode de décodage de données reçues turbo codées dans un récepteur à accès multiple par code de répartition CDMA, qui effectue, sur la base d'un rapport de signal sur interférence, le contrôle de puissance en boucle fermée d'un émetteur de données,
la méthode comprenant les étapes consistant à :
(a) pondérer des données reçues en diffusion inverse, sur la base du rapport de signal sur interférence, dans un contrôleur de puissance (101);
(b) effectuer, dans un turbo décodeur (101), une opération ACS ou une opération de comparaison/sélection dans un processus d'actualisation d'une métrique alpha, un processus d'actualisation d'une métrique bêta et un processus de calcul d'une vraisemblance, pour les données reçues ainsi pondérées; et
(c) compenser les résultats de l'opération ACS ou de l'opération de comparaison/sélection, dans au moins l'un du processus d'actualisation de la métrique alpha, du processus d'actualisation de la métrique bêta et du processus de calcul de la vraisemblance, sur la base d'une valeur prédéterminée associée à la différence générée lorsque l'opération ACS ou l'opération de comparaison/sélection est effectuée.
